# EUROPEAN PATENT APPLICATION

(11) **EP 4 593 062 A1**
(43) Date of publication of application: **30.07.2025**
(21) Application number: 23867885.8
(22) Date of filing: 24.07.2023
(51) Int. Cl.: H01L 21/304, H01L 21/306

(54) **SUBSTRATE PROCESSING APPARATUS AND SUBSTRATE PROCESSING METHOD**

(30) Priority: 22.09.2022 JP 2022151741
(71) Applicant: SCREEN Holdings Co., Ltd., Kyoto-shi, Kyoto 602-8585 (JP)
(72) Inventor: ENDO, Toru, Kyoto-shi, Kyoto 602-8585 (JP); AOKI, Rikuta, Kyoto-shi, Kyoto 602-8585 (JP)
(74) Representative: Kilian Kilian & Partner mbB
(86) International application number: PCT/JP2023/026916
(87) International publication number: WO 2024/062759

(57) **Abstract**

A substrate processing apparatus (100) includes a substrate holding portion (20) to hold and rotate a substrate (W) and a mixture supplying portion (50) to supply a sulfuric acid/hydrogen peroxide mixture, which is generated by mixing sulfuric acid and hydrogen peroxide water, to the substrate (W) rotated by the substrate holding portion (20). The mixture supplying portion (50) supplies the sulfuric acid/hydrogen peroxide mixture to the substrate at a first flow rate in a first period, and supplies the sulfuric acid/hydrogen peroxide mixture to the substrate at a second flow rate smaller than the first flow rate during a second period subsequent to the first period. A ratio of the sulfuric acid of the sulfuric acid/hydrogen peroxide mixture during the second period is smaller than a ratio of the sulfuric acid of the sulfuric acid/hydrogen peroxide mixture during the first period.

## Description

### Technical Field

The present invention relates to a substrate processing apparatus and a substrate processing method.

### Background Art

A substrate processing apparatus that processes a substrate has been heretofore used in a process for manufacturing devices that include substrates, such as a semiconductor device or a liquid crystal display device. The substrate is, for example, a semiconductor wafer or a glass substrate for a liquid crystal display device.

SPM processing is known as processing for peeling off a target object that has been fixed to a surface of a substrate. In the SPM processing, the target object that has been fixed to the surface of the substrate is peeled off by supplying a sulfuric acid/hydrogen peroxide mixture, in which sulfuric acid and hydrogen peroxide water are mixed, to the substrate.

SPM processing that processes a substrate with high-temperature SPM is described in Patent Literature 1. In a substrate processing apparatus of Patent Literature 1, a target object that has been fixed to a surface of a substrate is efficiently peeled off by moving a discharge position of an SPM nozzle outwardly from the center of the substrate in accordance with resist residues in SPM photographed by a camera. Also, Patent Literature 1 describes a process in which a substrate is processed with a first SPM rich in hydrogen peroxide water, and then processes the substrate with a second SPM rich in sulfuric acid. According to the technique of Patent Literature 1, it is possible to excellently remove remaining target objects by the second SPM.

### Citation List

### Patent Literature

Patent Literature 1: Japanese Patent Application Publication No. 2020-107779

### Summary of Invention

### Technical Problem

In the substrate processing apparatus of Patent Literature 1, it is possible to efficiently apply SPM processing to a substrate by supplying high-temperature SPM to the substrate. However, there is a case in which liquid droplets of the sulfuric acid/hydrogen peroxide mixture on the substrate splash to the surroundings when the substrate is processed by the high-temperature sulfuric acid/hydrogen peroxide mixture. If the liquid droplets of the sulfuric acid/hydrogen peroxide mixture splash from the substrate in this way and adhere to some members, there is a concern that the substrate will be dirtied because of adhering substances in the subsequent steps. On the other hand, there is a concern that the efficiency of SPM processing will be lowered if SPM processing is performed by low-temperature SPM.

The present invention has been made in consideration of the aforementioned problems, and aims to provide a substrate processing apparatus and a substrate processing method capable of efficiently performing SPM processing for a substrate while suppressing the splash of liquid droplets of a sulfuric acid/hydrogen peroxide mixture from the substrate.

### Solution to Problem

The substrate processing apparatus according to an aspect of the present invention includes a substrate holding portion to hold and rotate a substrate and a mixture supplying portion to supply a sulfuric acid/hydrogen peroxide mixture, in which sulfuric acid and hydrogen peroxide water are to be mixed, to the substrate that is rotated by the substrate holding portion. The mixture supplying portion supplies the sulfuric acid/hydrogen peroxide mixture to the substrate at a first flow rate during a first period, and supplies the sulfuric acid/hydrogen peroxide mixture to the substrate at a second flow rate that is smaller than the first flow rate during a second period subsequent to the first period, and a ratio of the sulfuric acid of the sulfuric acid/hydrogen peroxide mixture in the second period is smaller than a ratio of the sulfuric acid of the sulfuric acid/hydrogen peroxide mixture in the first period.

In a preferred embodiment, the substrate processing apparatus further includes an etching liquid supplying portion to supply an etching liquid to the substrate before the mixture supplying portion supplies the sulfuric acid/hydrogen peroxide mixture to the substrate.

In a preferred embodiment, the etching liquid supplying portion supplies hydrofluoric acid or diluted hydrofluoric acid to the substrate as the etching liquid.

In a preferred embodiment, the mixture supplying portion supplies the sulfuric acid/hydrogen peroxide mixture, which is generated by mixing the sulfuric acid of not less than 130°C and not more than 200°C and the hydrogen peroxide water of room temperature, to the substrate.

In a preferred embodiment, the mixture supplying portion supplies the sulfuric acid/hydrogen peroxide mixture in which the sulfuric acid and the hydrogen peroxide water are mixed at a ratio of 4:1 to 9:1 during the first period to the substrate, and supplies the sulfuric acid/hydrogen peroxide mixture in which the sulfuric acid and the hydrogen peroxide water are mixed at a ratio of 2:1 to 3:1 during the second period to the substrate.

In a preferred embodiment, the second period is longer than the first period.

In a preferred embodiment, the substrate holding portion rotates the substrate at a second rotation speed during the second period after rotating the substrate at a first rotation speed during the first period, and the second rotation speed is smaller than the first rotation speed.

In a preferred embodiment, the mixture supplying portion supplies the hydrogen peroxide water to the substrate after the second period.

In a preferred embodiment, the substrate processing apparatus further includes a splash suppression member to suppress a splash of liquid droplets of the sulfuric acid/hydrogen peroxide mixture from the substrate.

A substrate processing method according to another aspect of the present invention is a substrate processing method including an SPM processing step of supplying a sulfuric acid/hydrogen peroxide mixture, which is generated by mixing sulfuric acid and hydrogen peroxide water, to a substrate held and rotated by a substrate holding portion and processing the substrate with the sulfuric acid/hydrogen peroxide mixture, and the SPM processing step includes a first processing step of supplying the sulfuric acid/hydrogen peroxide mixture to the substrate at a first flow rate in a first period and processing the substrate and a second processing step of supplying the sulfuric acid/hydrogen peroxide mixture to the substrate at a second flow rate smaller than the first flow rate during a second period subsequent to the first period and processing the substrate, and a ratio of the sulfuric acid of the sulfuric acid/hydrogen peroxide mixture during the second period is smaller than a ratio of the sulfuric acid of the sulfuric acid/hydrogen peroxide mixture during the first period.

In a preferred embodiment, the substrate processing method further includes an etching step of processing the substrate with an etching liquid before the SPM processing step.

In a preferred embodiment, in the etching step, hydrofluoric acid or diluted hydrofluoric acid is supplied to the substrate as the etching liquid.

In a preferred embodiment, in the SPM processing step, the sulfuric acid/hydrogen peroxide mixture which is generated by mixing the sulfuric acid of not less than 130°C and not more than 220°C and the hydrogen peroxide water of room temperature is supplied to the substrate.

In a preferred embodiment, in the first processing step, the sulfuric acid/hydrogen peroxide mixture in which the sulfuric acid and the hydrogen peroxide water are mixed at a ratio of 4:1 to 9:1 during the first period is supplied to the substrate, and, in the second processing step, the sulfuric acid/hydrogen peroxide mixture in which the sulfuric acid and the hydrogen peroxide water are mixed at a ratio of 2:1 to 3:1 during the second period is supplied to the substrate.

In a preferred embodiment, the second period is longer than the first period.

In a preferred embodiment, in the SPM processing step, the substrate is rotated at a second rotation speed during the second period after rotating the substrate at a first rotation speed during the first period, and the second rotation speed is smaller than the first rotation speed.

In a preferred embodiment, the substrate processing method further includes a step of supplying the hydrogen peroxide water to the substrate after the second period and processing the substrate by use of the hydrogen peroxide water.

In a preferred embodiment, in the SPM processing step, a splash of liquid droplets of the sulfuric acid/hydrogen peroxide mixture is suppressed by a splash suppression member that faces a position of the substrate at which the sulfuric acid/hydrogen peroxide mixture reaches the substrate.

### Advantageous Effects of Invention

According to the present invention, it is possible to provide a substrate processing apparatus and a substrate processing method capable of efficiently performing SPM processing for a substrate while suppressing the splash of liquid droplets of a sulfuric acid/hydrogen peroxide mixture from the substrate.

### Brief Description of Drawings

[FIG. 1] is a schematic plan view of a substrate processing apparatus of the present preferred embodiment.
[FIG. 2] is a schematic view of a substrate processing unit of the substrate processing apparatus of the present preferred embodiment.
[FIG. 3] is a block diagram of the substrate processing apparatus of the present preferred embodiment.
[FIG. 4] is a graph showing the number of liquid droplets of a sulfuric acid/hydrogen peroxide mixture that have splashed from a substrate in accordance with the temperature of the sulfuric acid/hydrogen peroxide mixture.
[FIG. 5] is a graph showing the number of liquid droplets of the sulfuric acid/hydrogen peroxide mixture that have splashed from the substrate in accordance with the sulfuric acid ratio and the flow rate of the sulfuric acid/hydrogen peroxide mixture.
[FIG. 6] is a table showing the flow rate and the sulfuric acid ratio of the sulfuric acid/hydrogen peroxide mixture in first processing and second processing that are included in SPM processing of a substrate processing method of the present preferred embodiment.
[FIGs. 7] (a) to (c) are schematic views of the substrate processing apparatus of the present preferred embodiment.
[FIG. 8] is a flowchart of the substrate processing apparatus of the present preferred embodiment.
[FIGs. 9] (a) to (e) are schematic views of the substrate processing apparatus of the present preferred embodiment.
[FIGs. 10] (a) to (c) are schematic views of the substrate processing apparatus of the present preferred embodiment.
[FIG. 11] is a flowchart of the substrate processing apparatus of the present preferred embodiment.
[FIG. 12] is a schematic view of a substrate processing unit of the substrate processing apparatus of the present preferred embodiment.
[FIG. 13] is a schematic top view of the substrate processing unit of the substrate processing apparatus of the present preferred embodiment.
[FIG. 14] is a flowchart of the substrate processing apparatus of the present preferred embodiment.

### Description of Embodiments

Preferred embodiments of a substrate processing apparatus and a substrate processing method according to the present invention will be hereinafter described with reference to the drawings. It is noted that, in the drawings, the same reference sign is assigned to the same or equivalent element, and a repetitive description of the element is omitted. It is noted that, in the description of the present application, an X axis, a Y axis, and a Z axis perpendicular to each other are at times mentioned in order to facilitate the understanding of the invention. Typically, the X axis and the Y axis are parallel to each other, and the Z axis is parallel to a vertical direction.

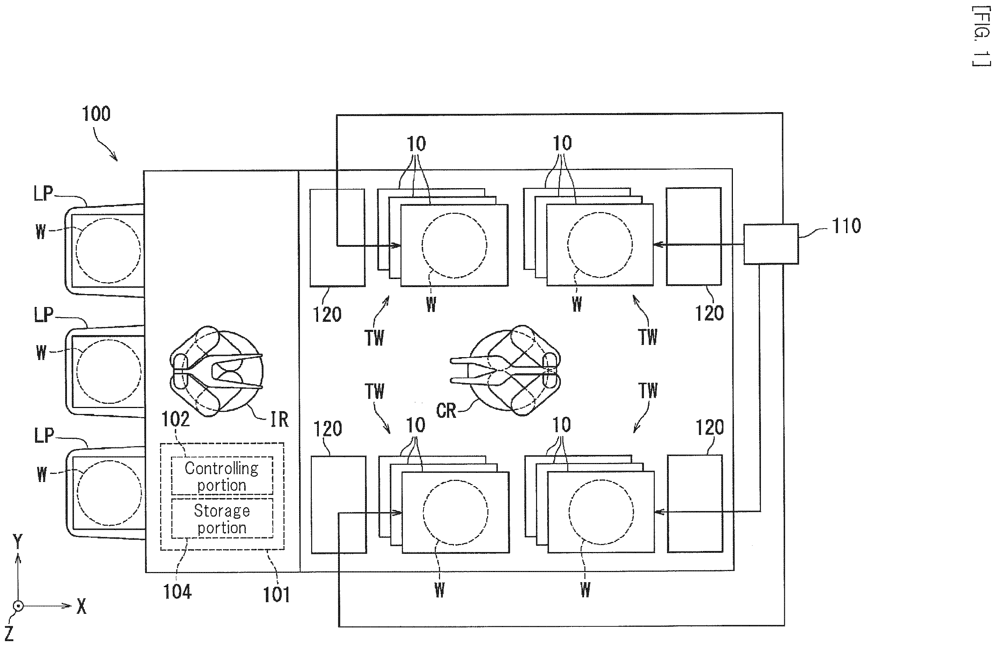

First, referring to FIG. 1, a preferred embodiment of a substrate processing apparatus 100 in accordance with the present invention will be described. FIG. 1 is a schematic plan view of the substrate processing apparatus 100 of the present preferred embodiment.

The substrate processing apparatus 100 processes a substrate W. The substrate processing apparatus 100 processes the substrate W such as to perform at least one among etching, surface processing, characteristic impartment, formation of processed film, removal of at least a portion of a film, and washing with respect to the substrate W.

The substrate W is used as a semiconductor substrate. The substrate W includes a semiconductor wafer. The substrate W has, for example, a substantially disk shape. Here, the substrate processing apparatus 100 processes substrates W one by one.

As shown in FIG. 1, the substrate processing apparatus 100 includes a plurality of substrate processing units 10, a processing liquid cabinet 110, a processing liquid box 120, a plurality of load ports LP, an indexer robot IR, a center robot CR, and a controller 101. The controller 101 controls the load port LP, the indexer robot IR, and the center robot CR. The controller 101 includes a controlling portion 102 and a storage portion 104. In this description, the indexer robot IR and the center robot CR are at times referred to generically as a transfer unit.

In each of the load ports LP, a plurality of substrates W are stacked and are housed. The indexer robot IR transfers the substrate W between the load port LP and the center robot CR. The center robot CR transfers the substrate W between the indexer robot IR and the substrate processing unit 10. Each of the substrate processing units 10 discharges a processing liquid to the substrate W, and processes the substrate W. The processing liquid includes a chemical liquid, a rinse liquid, and a removing liquid and/or a water-repellent agent. The processing liquid cabinet 110 houses the processing liquid. The processing liquid cabinet 110 may house a gas.

In detail, the substrate processing units 10 form a plurality of towers TW (four towers TW in FIG. 1) placed such as to surround the center robot CR in a plan view. Each of the towers TW includes the substrate processing units 10 (three substrate processing units 10 in FIG. 1) stacked upwardly and downwardly. Each of the processing liquid boxes 120 corresponds to the plurality of towers TW. A liquid in the processing liquid cabinet 110 is supplied to all of the substrate processing units 10 included in the tower TW corresponding to the processing liquid box 120 through any one of the processing liquid boxes 120. Also, a gas in the processing liquid cabinet 110 is supplied to all of the substrate processing units 10 included in the tower TW corresponding to the processing liquid box 120 through any one of the processing liquid boxes 120.

Typically, the processing liquid cabinet 110 has a storage tank (tank) that is used to prepare a processing liquid. The processing liquid cabinet 110 may have a storage tank for one kind of processing liquid, and may have a storage tank for a plurality of kinds of processing liquids. Also, the processing liquid cabinet 110 has a pump and a valve and/or a filter that are used to allow a processing liquid to flow.

The controller 101 controls various operations of the substrate processing apparatus 100. The substrate processing unit 10 processes a substrate W by means of the controller 101.

The controller 101 includes the controlling portion 102 and the storage portion 104. The controlling portion 102 has a processor. The controlling portion 102 has, for example, a central processing unit (CPU). Alternatively, the controlling portion 102 may have a general-purpose calculator.

The storage portion 104 stores data and a computer program. The data includes recipe data. The recipe data includes information showing a plurality of recipes. Each of the recipes defines the processing contents and the processing procedures of a substrate W.

The storage portion 104 includes a main storage device and an auxiliary storage device. The main storage device is, for example, a semiconductor memory. The auxiliary storage device is, for example, a semiconductor memory and/or a hard disk drive. The storage portion 104 may include a removable medium. The controlling portion 102 executes a computer program stored by the storage portion 104, and executes a substrate processing operation.

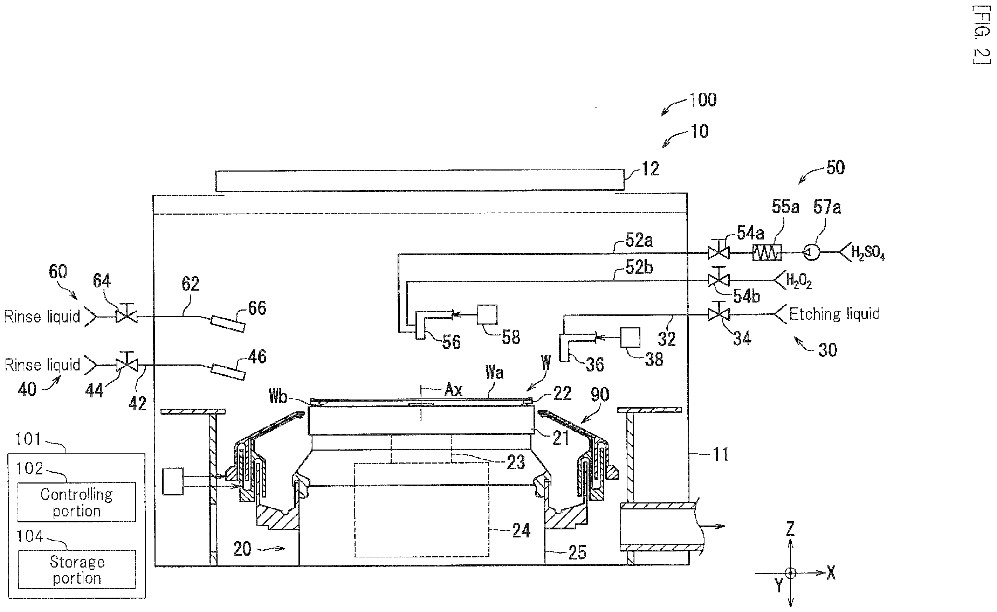

Next, referring to FIG. 2, the substrate processing unit 10 of the substrate processing apparatus 100 of the present preferred embodiment will be described. FIG. 2 is a schematic view of the substrate processing unit 10 of the substrate processing apparatus 100.

The substrate processing unit 10 is composed of a chamber 11, a blower unit 12, a substrate holding portion 20, an etching liquid supplying portion 30, a rinse liquid supplying portion 40, an SPM supplying portion 50, and a rinse liquid supplying portion 60.

The chamber 11 is formed substantially in box shape having an internal space. The chamber 11 houses a substrate **W.** Here, the substrate processing apparatus 100 is a single substrate processing type apparatus that processes substrates W one by one, and the substrate W is housed in the chamber 11 one by one. The substrate W is housed in the chamber 11, and is processed in the chamber 11. At least a portion of each of the substrate holding portion 20, the etching liquid supplying portion 30, the rinse liquid supplying portion 40, the SPM supplying portion 50, and the rinse liquid supplying portion 60 is housed in the chamber 11.

The blower unit 12 is placed over the chamber 11. For example, the blower unit 12 is placed on a top surface of the chamber 11. The blower unit 12 sends air into the chamber 11. The blower unit 12 includes, for example, a fan filter unit (FFU). A down flow (downward flow) is formed in the chamber 11 by means of the blower unit 12 and an exhaust device (not shown).

The substrate holding portion 20 holds a substrate W. The substrate holding portion 20 directs an upper surface (front surface) Wa of the substrate W upwardly, and horizontally holds the substrate W such as to direct a rear surface (lower surface) Wb of the substrate W downwardly in a vertical direction. Also, the substrate holding portion 20 rotates the substrate W in a state of holding the substrate W. For example, a laminated structure in which a recess is formed is provided on the upper surface Wa of the substrate W. The substrate holding portion 20 rotates the substrate W while holding the substrate W.

For example, the substrate holding portion 20 may be a pinching type that pinches an end portion of the substrate W. Alternatively, the substrate holding portion 20 may have an arbitrary mechanism that holds the substrate W from the rear surface Wb. For example, the substrate holding portion 20 may be a vacuum type. In this case, the substrate holding portion 20 horizontally holds the substrate W by suctioning a central portion of the rear surface Wb of the substrate W that is a non-device-forming surface onto the upper surface. Alternatively, the substrate holding portion 20 may combine the pinching type and the vacuum type that bring a plurality of chuck pins into contact with a peripheral end surface of the substrate W.

For example, the substrate holding portion 20 includes a spin base 21, a chuck member 22, a shaft 23, a spin motor 24, and a housing 25. The chuck member 22 is provided at the spin base 21. The chuck member 22 chucks the substrate W. Typically, the plurality of chuck members 22 are provided at the spin base 21.

The shaft 23 extends in the vertical direction along a rotation axis Ax. The spin base 21 is joined to an upper end of the shaft 23. The substrate W is placed over the spin base 21.

The spin base 21 has a disk shape. The chuck member 22 horizontally supports the substrate W. The shaft 23 extends downwardly from a central portion of the spin base 21. The spin motor 24 gives a rotational force to the shaft 23. The spin motor 24 rotates, by rotating the shaft 23 in the rotational direction, the substrate W and the spin base 21 centering around the rotation axis Ax. The housing 25 houses the shaft 23 and the spin motor 24.

The etching liquid supplying portion 30 supplies an etching liquid to the substrate W. Typically, the etching liquid supplying portion 30 supplies an etching liquid to the upper surface Wa of the substrate W. At least a portion of the etching liquid supplying portion 30 is housed in the chamber 11.

The etching liquid supplying portion 30 supplies an etching liquid to the upper surface Wa of the substrate W. The etching liquid includes hydrofluoric acid or diluted hydrofluoric acid. For example, hydrofluoric acid may be heated to not less than 40°C and not more than 70°C, or may be heated to not less than 50°C and not more than 60°C. However, hydrofluoric acid is not necessarily required to be heated.

The etching liquid supplying portion 30 includes a piping 32, a valve 34, and a nozzle 36. The nozzle 36 discharges an etching liquid to the upper surface Wa of the substrate W. The nozzle 36 is connected to the piping 32. An etching liquid is supplied from a supply source to the piping 32.

The valve 34 opens and closes a flow path in the piping 32. The valve 34 adjusts the opening degree of the piping 32, and adjusts the flow rate of the etching liquid supplied to the piping 32. In detail, the valve 34 includes a valve body (not shown) inside which a valve seat is provided, a valve element to open and close the valve seat, and an actuator (not shown) to move the valve element between an open position and a closed position.

The nozzle 36 may be arranged such as to be movable with respect to the substrate W. The etching liquid supplying portion 30 may further have a nozzle moving portion 38. The nozzle moving portion 38 may elevate and lower the nozzle 36, and may horizontally turn the nozzle 36 around a turning axis. The nozzle moving portion 38 elevates and lowers the nozzle 36. For example, the nozzle moving portion 38 includes a ball screw mechanism and an electric motor that gives a driving force to the ball screw mechanism. Also, the nozzle moving portion 38 horizontally turns the nozzle 36. For example, the nozzle moving portion 38 includes an electric motor.

The rinse liquid supplying portion 40 supplies a rinse liquid to the substrate W. Typically, the rinse liquid supplying portion 40 supplies a rinse liquid to the upper surface Wa of the substrate W. At least a portion of the rinse liquid supplying portion 40 is housed in the chamber 11.

The rinse liquid supplying portion 40 supplies a rinse liquid to the upper surface Wa of the substrate W. Typically, the rinse liquid includes carbonated water. Alternatively, the rinse liquid may be a liquid other than carbonated water. For example, deionized water (DIW), electrolyzed ion water, ozone water, ammonia water, aqueous hydrochloric acid solution of dilute concentration (for example, approximately 10 ppm to 100 ppm), or reduced water (hydrogen water) can be mentioned as an example of the rinse liquid.

The rinse liquid supplying portion 40 includes a piping 42, a valve 44, and a nozzle 46. The nozzle 46 discharges a rinse liquid to the upper surface Wa of the substrate W. The nozzle 46 is connected to the piping 42. A rinse liquid is supplied from a supply source to the piping 42. The valve 44 opens and closes a flow path in the piping 42. The nozzle 46 may be arranged such as to be movable with respect to the substrate W.

The valve 44 opens and closes the flow path in the piping 42. The valve 44 adjusts the opening degree of the piping 42, and adjusts the flow rate of the rinse liquid supplied to the piping 42. In detail, the valve 44 includes a valve body (not shown) inside which a valve seat is provided, a valve element to open and close the valve seat, and an actuator (not shown) to move the valve element between an open position and a closed position.

The nozzle 46 may be movable. The nozzle 46 is movable in the horizontal direction and/or the vertical direction in accordance with a moving mechanism controlled by the controlling portion 102.

The SPM supplying portion 50 supplies a sulfuric acid/hydrogen peroxide mixture to the substrate W. Typically, the SPM supplying portion 50 supplies a sulfuric acid/hydrogen peroxide mixture to the upper surface Wa of the substrate W. The sulfuric acid/hydrogen peroxide mixture may be heated to not less than 90°C and not more than 240°C. At least a portion of the SPM supplying portion 50 is housed in the chamber 11. In this description, the SPM supplying portion 50 is at times referred to as a mixture supplying portion 50.

The SPM supplying portion (mixture supplying portion) 50 has a piping 52a, a valve 54a, a piping 52b, a valve 54b, a heater 55a, a pump 57a, and a nozzle 56. The nozzle 56 discharges a sulfuric acid/hydrogen peroxide mixture to the upper surface Wa of the substrate W.

Here, the nozzle 56 is connected to the piping 52a and to the piping 52b. Sulfuric acid is supplied from a supply source to the piping 52a. The valve 54a opens and closes a flow path in the piping 52a. The valve 54a adjusts the opening degree of the piping 52a, and adjusts the flow rate of the sulfuric acid supplied to the piping 52a. In detail, the valve 54a includes a valve body (not shown) inside which a valve seat is provided, a valve element to open and close the valve seat, and an actuator (not shown) to move the valve element between an open position and a closed position.

The pump 57a allows sulfuric acid to flow into the piping 52a. The heater 55a heats the sulfuric acid flowing through the piping 52a. The temperature of the sulfuric acid is adjustable by the heater 55a. The heater 55a heats the sulfuric acid flowing through the piping 52a, and adjusts the temperature of the sulfuric acid (e.g., about 70°C to 220°C). The heater 55a may heat the sulfuric acid and may measure the temperature of the sulfuric acid.

Hydrogen peroxide water is supplied from a supply source to the piping 52b. The valve 54b opens and closes a flow path in the piping 52b. The valve 54b adjusts the opening degree of the piping 52b, and adjusts the flow rate of the hydrogen peroxide water supplied to the piping 52b. In detail, the valve 54b includes a valve body (not shown) inside which a valve seat is provided, a valve element to open and close the valve seat, and an actuator (not shown) to move the valve element between an open position and a closed position.

Here, sulfuric acid that has flowed into the piping 52a is mixed with hydrogen peroxide water that has flowed into the piping 52b, and a sulfuric acid/hydrogen peroxide is generated in the nozzle 56. The temperature of the sulfuric acid/hydrogen peroxide is elevated by mixing the sulfuric acid and the hydrogen peroxide water.

The nozzle 56 may be arranged such as to be movable with respect to the substrate W. The SPM supplying portion 50 may further have a nozzle moving portion 58. The nozzle moving portion 58 may elevate and lower the nozzle 56, and may horizontally turn the nozzle 56 around the turning axis. The nozzle moving portion 58 elevates and lowers the nozzle 56. For example, the nozzle moving portion 58 includes a ball screw mechanism and an electric motor to give a driving force to the ball screw mechanism. Also, the nozzle moving portion 58 horizontally turns the nozzle 56. For example, the nozzle moving portion 58 includes an electric motor.

It is noted that, when the valve 54a is opened and sulfuric acid flows through the piping 52a, and when the valve 54b is opened and hydrogen peroxide water flows through the piping 52b, the SPM supplying portion 50 supplies a sulfuric acid/hydrogen peroxide mixture from the nozzle 56 to the substrate W. Also, when the valve 54a is closed and sulfuric acid does not flow through the piping 52a, and when the valve 54b is opened and hydrogen peroxide water flows through the piping 52b, the SPM supplying portion 50 supplies hydrogen peroxide water from the nozzle 56 to the substrate W. Further, when the valve 54a is opened and sulfuric acid flows through the piping 52a, and when the valve 54b is closed and hydrogen peroxide water does not flow through the piping 52b, the SPM supplying portion 50 supplies sulfuric acid from the nozzle 56 to the substrate W.

The rinse liquid supplying portion 60 supplies a rinse liquid to the substrate W. Typically, the rinse liquid supplying portion 60 supplies a rinse liquid to the upper surface Wa of the substrate W. At least a portion of the rinse liquid supplying portion 60 is housed in the chamber 11.

The rinse liquid supplying portion 60 supplies a rinse liquid to the upper surface Wa of the substrate W. Deionized water (DIW), carbonated water, electrolyzed ion water, ozone water, ammonia water, aqueous hydrochloric acid solution of dilute concentration (for example, approximately 10 ppm to 100 ppm), or reduced water (hydrogen water) can be mentioned as an example of the rinse liquid.

The rinse liquid supplying portion 60 includes a piping 62, a valve 64, and a nozzle 66. The nozzle 66 discharges a rinse liquid to the upper surface Wa of the substrate W. The nozzle 66 is connected to the piping 62. A rinse liquid is supplied from a supply source to the piping 62. The valve 64 opens and closes a flow path in the piping 62. The nozzle 66 may be arranged such as to be movable with respect to the substrate W.

The valve 64 opens and closes the flow path in the piping 62. The valve 64 adjusts the opening degree of the piping 62, and adjusts the flow rate of the rinse liquid supplied to the piping 62. In detail, the valve 64 includes a valve body (not shown) inside which a valve seat is provided, a valve element to open and close the valve seat, and an actuator (not shown) to move the valve element between an open position and a closed position (not shown).

The nozzle 66 may be movable. The nozzle 66 is movable in the horizontal direction and/or the vertical direction in accordance with the moving mechanism controlled by the controlling portion 102.

The substrate processing unit 10 further includes a cup 90. The cup 90 collects a processing liquid scattered from the substrate W. The cup 90 is elevated and lowered. For example, the cup 90 is vertically upwardly elevated to a lateral side of the substrate W during a period of time during which the etching liquid supplying portion 30, the rinse liquid supplying portion 40, the SPM supplying portion 50, and/or the rinse liquid supplying portion 60 supply an etching liquid, a rinse liquid, an SPM and/or a rinse liquid to the substrate W. In this case, the cup 90 collects the etching liquid, the rinse liquid, and the SPM and/or the rinse liquid that are scattered from the substrate W due to the rotation of the substrate W. Also, the cup 90 is vertically downwardly lowered from the lateral side of the substrate W when the period of time is finished during which the etching liquid supplying portion 30, the rinse liquid supplying portion 40, the SPM supplying portion 50, and/or the rinse liquid supplying portion 60 supply the etching liquid, the rinse liquid, the SPM and/or the rinse liquid to the substrate W.

As described above, the controller 101 includes the controlling portion 102 and the storage portion 104. The controlling portion 102 controls the blower unit 12, the substrate holding portion 20, the etching liquid supplying portion 30, the rinse liquid supplying portion 40, the SPM supplying portion 50, the rinse liquid supplying portion 60, and/or the cup 90. In an example, the controlling portion 102 controls the blower unit 12, the spin motor 24, the valves 34, 44, 54a, 54b, 64, the nozzle moving portions 38, 58, the heater 55a, the pump 57a, and/or the cup 90.

The substrate processing apparatus 100 of the present preferred embodiment is suitably used to manufacture a semiconductor device provided with a semiconductor. Typically, in the semiconductor device, a conductive layer and an insulating layer are stacked on a base material. The substrate processing apparatus 100 is suitably used for washing the conductive layer and/or the insulating layer and/or processing the conductive layer and/or the insulating layer (e.g., etching, characteristic change, etc.) when the semiconductor device is produced.

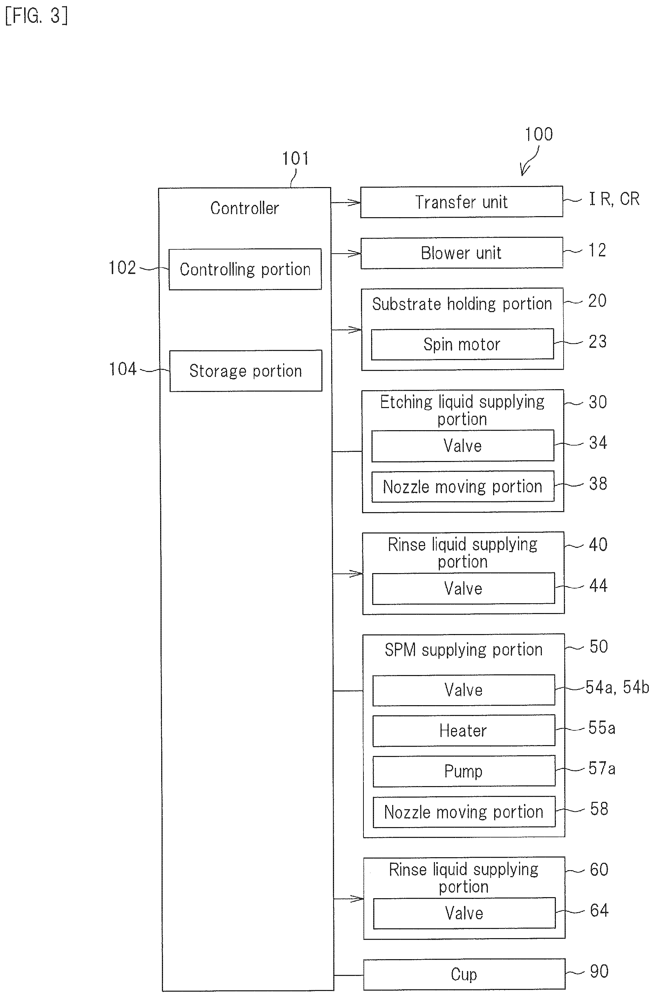

Next, referring to FIG. 1 to FIG. 3, the substrate processing apparatus 100 of the present preferred embodiment will be described. FIG. 3 is a block diagram of the substrate processing apparatus 100.

As shown in FIG. 3, the controller 101 controls various operations of the substrate processing apparatus 100. The controller 101 controls the indexer robot IR, the center robot CR, the blower unit 12, the substrate holding portion 20, the etching liquid supplying portion 30, the rinse liquid supplying portion 40, the SPM supplying portion 50, the rinse liquid supplying portion 60, and the cup 90. In detail, the controller 101 transmits a control signal to the indexer robot IR, the center robot CR, the blower unit 12, the substrate holding portion 20, the etching liquid supplying portion 30, the rinse liquid supplying portion 40, the SPM supplying portion 50, the rinse liquid supplying portion 60, and the cup 90, and thereby controls the indexer robot IR, the center robot CR, the blower unit 12, the substrate holding portion 20, the etching liquid supplying portion 30, the rinse liquid supplying portion 40, the SPM supplying portion 50, the rinse liquid supplying portion 60, and the cup 90.

Also, the storage portion 104 stores a computer program and data. The data includes recipe data. The recipe data includes information showing a plurality of recipes. Each of the recipes defines the processing contents, the processing procedures, and the substrate processing conditions of the substrate W. The controlling portion 102 executes a computer program stored by the storage portion 104, and executes a substrate processing operation.

The controlling portion 102 controls the indexer robot IR, and transfers the substrate W by means of the indexer robot IR.

The controlling portion 102 controls the center robot CR, and transfers the substrate W by means of the center robot CR. For example, the center robot CR receives a not-yet-processed substrate W, and carries the substrate W into any one of the chambers 11. Also, the center robot CR receives a processed substrate W from the chamber 11, and carries the substrate W out.

The controlling portion 102 controls the blower unit 12, and sends air into the chamber 11. For example, the controlling portion 102 controls the blower unit 12 and the exhaust device (not shown), and forms a down flow in the chamber 11.

The controlling portion 102 controls the substrate holding portion 20, and controls the attachment/detachment of the substrate W, the start of the rotation of the substrate W, the change of the rotation speed, and the stop of the rotation of the substrate W. For example, the controlling portion 102 is enabled to change the rotation speed of the substrate holding portion 20 while controlling the substrate holding portion 20. In detail, the controlling portion 102 is capable of changing the rotation speed of the substrate W by changing the rotation speed of the spin motor 24 of the substrate holding portion 20.

The controlling portion 102 is capable of switching the state of the valve 34 between an open state and a closed state while controlling the valve 34 of the etching liquid supplying portion 30. In detail, by controlling the valve 34 of the etching liquid supply portion 30 and bringing the valve 34 into an open state, the controlling portion 102 is capable of allowing an etching liquid flowing through the piping 32 toward the nozzle 36 to pass through. Also, by controlling the valve 34 of the etching liquid supply portion 30 and bringing the valve 34 into a closed state, the controlling portion 102 is capable of stopping the supply of the etching liquid flowing through the piping 32 toward the nozzle 36.

The controlling portion 102 is capable of switching the state of the valve 44 between an open state and a closed state while controlling the valve 44 of the rinse liquid supplying portion 40. In detail, by controlling the valve 44 of the rinse liquid supplying portion 40 and bringing the valve 44 into an open state, the controlling portion 102 is capable of allowing a rinse liquid flowing through the piping 42 toward the nozzle 46 to pass through. Also, by controlling the valve 44 of the rinse liquid supplying portion 40 and bringing the valve 44 into a closed state, the controlling portion 102 is capable of stopping the supply of the rinse liquid flowing through the piping 42 toward the nozzle 46.

The controlling portion 102 is capable of switching the state of the valve 54a between an open state and a closed state while controlling the valve 54a. In detail, by controlling the valve 54a and bringing the valve 54a into an open state, the controlling portion 102 is capable of allowing sulfuric acid flowing through the piping 52a toward the nozzle 56 to pass through. Also, by controlling the valve 54a and bringing the valve 54a into a closed state, the controlling portion 102 is capable of stopping the supply of the sulfuric acid flowing through the piping 52a toward the nozzle 56.

The controlling portion 102 is capable of switching the state of the valve 54b between an open state and a closed state while controlling the valve 54b. In detail, by controlling the valve 54b and bringing the valve 54b into an open state, the controlling portion 102 is capable of allowing hydrogen peroxide water flowing through the piping 52b toward the nozzle 56 to pass through. Also, by controlling the valve 54b and bringing the valve 54b into a closed state, the controlling portion 102 is capable of stopping the supply of the hydrogen peroxide water flowing through the piping 52b toward the nozzle 56.

Also, by controlling the valves 54a and 54b and bringing the valves 54a and 54b into an open state, the controlling portion 102 is capable of allowing sulfuric acid and hydrogen peroxide water to flow through the pipings 52a and 52b toward the nozzle 56 and discharging a sulfuric acid/hydrogen peroxide mixture from the nozzle 56. Also, by controlling the valves 54a and 54b and bringing the valves 54a and 54b into a closed state, the controlling portion 102 is capable of stopping the discharge of the sulfuric acid/hydrogen peroxide mixture from the nozzle 56.

The controlling portion 102 is capable of switching the state of the valve 64 between an open state and a closed state while controlling the valve 64 of the rinse liquid supplying portion 60. In detail, by controlling the valve 64 of the rinse liquid supplying portion 60 and bringing the valve 64 into an open state, the controlling portion 102 is capable of allowing a rinse liquid flowing through the piping 62 toward the nozzle 66 to pass through. Also, by controlling the valve 64 of the rinse liquid supplying portion 60 and bringing the valve 64 into a closed state, the controlling portion 102 is capable of stopping the supply of the rinse liquid flowing through the piping 62 toward the nozzle 66.

The controlling portion 102 may move the cup 90 with respect to the substrate W while controlling the cup 90. In detail, the controlling portion 102 vertically upwardly elevates the cup 90 to a lateral side of the substrate W during a period of time during which the etching liquid supplying portion 30, the rinse liquid supplying portion 40, the SPM supplying portion 50, and/or the rinse liquid supplying portion 60 supply an etching liquid, a rinse liquid, and an SPM and/or rinse liquid to the substrate W. Also, the controlling portion 102 vertically downwardly lowers the cup 90 from the lateral side of the substrate W when a period of time is finished during which the etching liquid supplying portion 30, the rinse liquid supplying portion 40, the SPM supplying portion 50, and/or the rinse liquid supplying portion 60 supply an etching liquid, a rinse liquid, an SPM and/or rinse liquid to the substrate W.

The substrate processing apparatus 100 of the present preferred embodiment is suitably used to form a semiconductor device. For example, the substrate processing apparatus 100 is suitably used to process a substrate W that is used as a semiconductor device having a laminated structure. The semiconductor device is a memory (storage device) having a so-called 3D structure. As an example, the substrate W is suitably used as a NAND type flash memory.

When the substrate is processed by a high-temperature sulfuric acid/hydrogen peroxide mixture, there is a case in which liquid droplets of the sulfuric acid/hydrogen peroxide mixture splash from the substrate. The substrate changes into a hydrophilic one by processing a hydrophobic substrate by use of the sulfuric acid/hydrogen peroxide mixture. At this time, if the sulfuric acid/hydrogen peroxide mixture has a high temperature, the sulfuric acid/hydrogen peroxide mixture will intensely react with the substrate, and liquid droplets of the sulfuric acid/hydrogen peroxide mixture will splash from the substrate. For example, when the substrate is etched with hydrofluoric acid or diluted hydrofluoric acid, the substrate shows hydrophobicity. Thereafter, if the sulfuric acid/hydrogen peroxide mixture has a high temperature when the substrate is processed by the sulfuric acid/hydrogen peroxide mixture and changes into a hydrophilic one, liquid droplets of the sulfuric acid/hydrogen peroxide mixture will splash from the substrate in some cases.

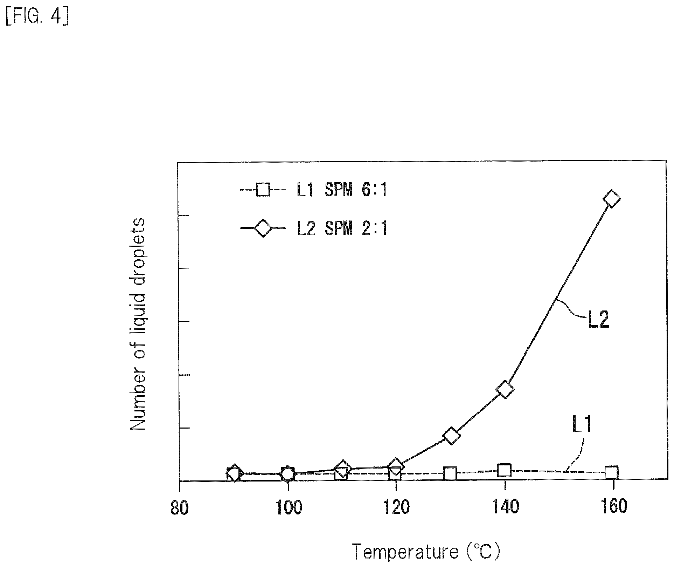

Next, referring to FIG. 4, a description will be given of the splash of liquid droplets of the sulfuric acid/hydrogen peroxide mixture according to the temperature and the sulfuric acid ratio of the sulfuric acid/hydrogen peroxide mixture. FIG. 4 is a graph showing a change in the number of liquid droplets of the sulfuric acid/hydrogen peroxide mixture that have splashed from the substrate according to the heating temperature of sulfuric acid. Results of sulfuric acid/hydrogen peroxide mixtures that differ in the sulfuric acid ratio from each other are shown in FIG. 4. In FIG. 4, line L1 shows a result of a case in which the ratio between sulfuric acid and hydrogen peroxide water is 6:1 in the sulfuric acid/hydrogen peroxide mixture, and line L2 shows a result of a case in which the ratio between sulfuric acid and hydrogen peroxide water is 2:1 in the sulfuric acid/hydrogen peroxide mixture.

As shown in line L1 of FIG. 4, when the sulfuric acid ratio of the sulfuric acid/hydrogen peroxide mixture is a comparatively high, the number of liquid droplets of the sulfuric acid/hydrogen peroxide mixture that have splashed from the substrate hardly changes even when the temperature of the sulfuric acid becomes high. On the other hand, as shown in line L2 of FIG. 4, when the sulfuric acid ratio of the sulfuric acid/hydrogen peroxide mixture is comparatively, the number of liquid droplets increases if the temperature of the sulfuric acid becomes high. For example, the number of liquid droplets rapidly increases if the temperature of the sulfuric acid exceeds 120°C. Presumably, the reason is that the sulfuric acid/hydrogen peroxide mixture intensely reacts on the substrate if the sulfuric acid ratio of the sulfuric acid/hydrogen peroxide mixture is low and if the temperature of the sulfuric acid/hydrogen peroxide mixture is high, and therefore the number of liquid droplets (liquid-droplet number) of the sulfuric acid/hydrogen peroxide mixture that have splashed from the substrate increases.

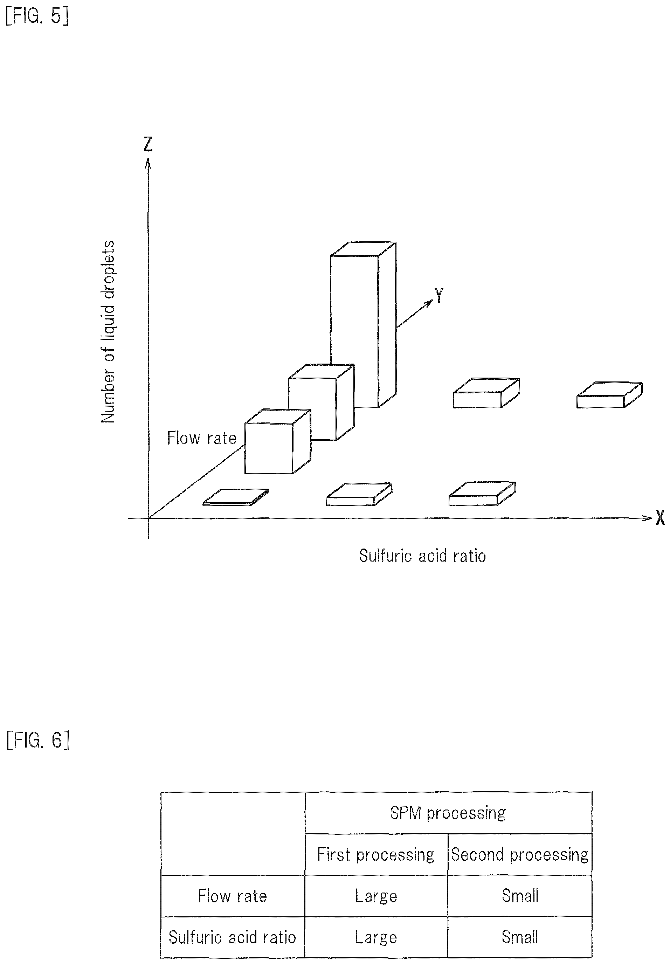

Next, referring to FIG. 5, a description will be given of the extent of the splash of the sulfuric acid/hydrogen peroxide mixture according to the temperature of the sulfuric acid/hydrogen peroxide mixture. FIG. 5 is a graph showing the number of liquid droplets according to the sulfuric acid ratio and the flow rate of the sulfuric acid/hydrogen peroxide mixture. In FIG. 5, the X axis represents the sulfuric acid ratio, and the Y axis represents the flow rate, and the Z axis represents the number of liquid droplets (liquid-droplet number) of the sulfuric acid/hydrogen peroxide mixture that have splashed from the substrate. It is noted that, in FIG. 5, the result of the minimum value of the X axis is a result obtained when the substrate is processed by use of a sulfuric acid/hydrogen peroxide mixture in which the ratio between sulfuric acid and hydrogen peroxide water is 2:1, and the result of the maximum value of the X axis is a result obtained when the substrate is processed by use of a sulfuric acid/hydrogen peroxide mixture in which the ratio between sulfuric acid and hydrogen peroxide water is 9:1.

It is understood from a change along the Y axis in FIG. 5 that there is a tendency for the number of liquid droplets to become higher in proportion to an increase in the flow rate of the sulfuric acid/hydrogen peroxide mixture. Also, it is understood from a change along the X axis in FIG. 5 that there is a tendency for the number of liquid droplets to become higher in proportion to a decrease in the sulfuric acid ratio of the sulfuric acid/hydrogen peroxide mixture. Presumably, the reason is that, in general, the degree of a rise in temperature of the sulfuric acid/hydrogen peroxide mixture becomes lower in proportion to an increase of the sulfuric acid ratio of the sulfuric acid/hydrogen peroxide mixture from the ratio 2:1 between the sulfuric acid and the hydrogen peroxide water as a contributory factor.

Liquid droplets more easily adhere to the inside of the chamber in proportion to an increase in the number of liquid droplets, and therefore it becomes more difficult to appropriately process the substrate. Therefore, from the viewpoint of reducing the number of liquid droplets, it is preferable to process the substrate by use of a sulfuric acid/hydrogen peroxide mixture having a comparatively low temperature and having a comparatively high sulfuric acid ratio. On the other hand, from the viewpoint of applying SPM processing onto the substrate, it is preferable to process the substrate by use of a sulfuric acid/hydrogen peroxide mixture having a comparatively high temperature and having a comparatively low sulfuric acid ratio.

Based on the aforementioned findings, when SPM processing is applied onto the substrate W by use of a sulfuric acid/hydrogen peroxide mixture, the substrate W is first processed by use of the sulfuric acid/hydrogen peroxide mixture having a high flow rate and having a high sulfuric acid ratio, and the substrate W is then processed by use of the sulfuric acid/hydrogen peroxide mixture having a low flow rate and having a low sulfuric acid ratio in the substrate processing apparatus 100 of the present preferred embodiment.

Next, referring to FIG. 1 to FIG. 6, the substrate processing method of the present preferred embodiment will be described. FIG. 6 is a table showing SPM processing in the substrate processing method of the present preferred embodiment.

As shown in FIG. 6, in the present preferred embodiment, the SPM processing includes first processing and second processing. The SPM processing starts from the first processing. The first processing is performed during a first period. The second processing starts after the end of the first processing. The second processing is performed during a second period after the first period. Typically, the second period starts continuously after the end of the first period.

First, in the first processing, the substrate W is processed by use of a sulfuric acid/hydrogen peroxide mixture having a high flow and a high sulfuric acid ratio. For example, the opening degrees of the valve 54a and the valve 54b are comparatively enlarged, and the flow rates of the sulfuric acid and the hydrogen peroxide water flowing through the pipings 52a and 52b are comparatively enlarged. Also, the ratio of the flow rate of the sulfuric acid flowing through the piping 52a to the total of the flow rates of the sulfuric acid and the hydrogen peroxide water flowing through the piping 52a and the piping 52b is set to be comparatively high.

In the second processing subsequent to the first processing, the substrate W is processed by use of a sulfuric acid/hydrogen peroxide mixture having a low flow rate and a low sulfuric acid ratio. For example, the opening degrees of the valve 54a and the valve 54b are set to be comparatively low, and the flow rates of the sulfuric acid and the hydrogen peroxide water flowing through the piping 52a and the piping 52b are set to be comparatively low. Also, the ratio of the flow rate of the sulfuric acid flowing through the piping 52a to the total of the flow rates of the sulfuric acid and the hydrogen peroxide water flowing through the piping 52a and the piping 52b is set to be comparatively low.

According to the substrate processing method of the present preferred embodiment, the substrate W is processed by a sulfuric acid/hydrogen peroxide mixture having a high flow rate in the first processing. Therefore, swiftly cover the upper surface Wa of the substrate W with the sulfuric acid/hydrogen peroxide mixture, and it is possible to suppress the adhesion of particles to the substrate W. Also, the sulfuric acid ratio of the sulfuric acid/hydrogen peroxide mixture is high in the first processing, and therefore it is possible to suppress the liquid splash of the sulfuric acid/hydrogen peroxide mixture.

According to the substrate processing method of the present preferred embodiment, the substrate W is processed by a sulfuric acid/hydrogen peroxide mixture having a low sulfuric acid ratio in the second processing. The sulfuric acid ratio of the sulfuric acid/hydrogen peroxide mixture is low in the second processing, and therefore it is possible to process the substrate W in a short time by use of the sulfuric acid/hydrogen peroxide mixture. Also, the substrate W is processed by a sulfuric acid/hydrogen peroxide mixture having a low flow rate in the second processing, and therefore it is possible to reduce the amount of consumption of the sulfuric acid/hydrogen peroxide mixture in the SPM processing.

It is noted that, in the above description with reference to FIG. 4 to FIG. 6, the liquid splash depends on the temperature, the sulfuric acid ratio, and the flow rate of the sulfuric acid/hydrogen peroxide mixture, and yet the liquid splash also depends on the rotation speed of the substrate W. Typically, it becomes easier for the liquid splash to occur in proportion to an increase in the rotation speed of the substrate W, and it becomes more difficult for the liquid splash to occur in proportion to a decrease in the rotation speed of the substrate W. Therefore, preferably, the rotation speed of the substrate W is lower than a threshold value in the first processing.

On the other hand, preferably, the temperature of the sulfuric acid/hydrogen peroxide mixture on the substrate W is kept comparatively high in the second processing. Also, if the rotation speed of the substrate W is high in the second processing, a liquid film becomes thin, and the efficiency of the SPM processing is lowered in some cases. Therefore, the rotation speed of the substrate W in the second processing may be made lower than the rotation speed of the substrate W in the first processing.

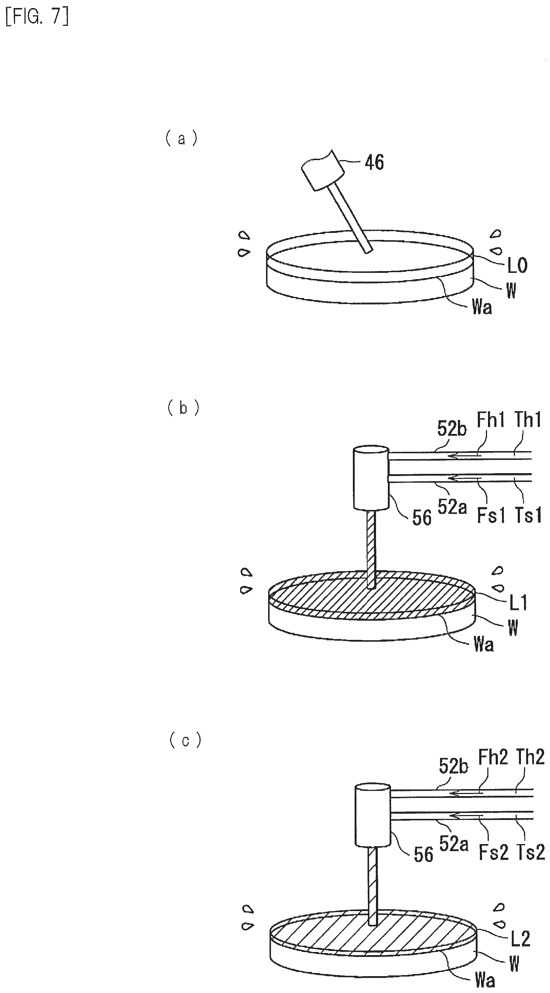

Next, referring to FIG. 1 to FIG. 7, the substrate processing method of the present preferred embodiment will be described. FIG. 7(a) to FIG. 7(c) are schematic views of the substrate processing method of the present preferred embodiment.

As shown in FIG. 7(a), a rinse liquid is supplied to the substrate W. The rinse liquid supplying portion 40 supplies the rinse liquid from the nozzle 46 to the substrate W by controlling the controlling portion 102. The substrate W is thereby rinsed.

The rinse liquid is supplied from the nozzle 46 to the substrate W which is rotating. When the rinse liquid is discharged to the center of the substrate W, the rinse liquid spreads in a radial direction from the center of the substrate W by means of a centrifugal force, and spreads through the entirety of the upper surface Wa of the substrate W. At this time, the rinse liquid forms a film having a liquid thickness L0.

As shown in FIG. 7(b), a sulfuric acid/hydrogen peroxide mixture is supplied to the substrate W and the first processing is applied onto the substrate W. The SPM supplying portion 50 supplies the sulfuric acid/hydrogen peroxide mixture from the nozzle 56 to the substrate W by controlling the controlling portion 102. Here, the valve 54a is opened, and the sulfuric acid flows through the piping 52a, and the valve 54b is opened, and the hydrogen peroxide water flows through the piping 52b, and the sulfuric acid/hydrogen peroxide mixture which is generated by mixing the sulfuric acid and the hydrogen peroxide water in the nozzle 56 is discharged from the nozzle 56.

The sulfuric acid/hydrogen peroxide mixture is supplied to the rotating substrate W from the nozzle 56. When the sulfuric acid/hydrogen peroxide mixture is discharged to the center of the substrate W, the sulfuric acid/hydrogen peroxide mixture spreads in the radial direction from the center of the substrate W by means of a centrifugal force, and spreads through the entirety of the upper surface Wa of the substrate W. At this time, the sulfuric acid/hydrogen peroxide mixture forms a film having a liquid thickness L1.

The sulfuric acid/hydrogen peroxide mixture is supplied to the rotating substrate W in this way, and the substrate W is processed by use of the sulfuric acid/hydrogen peroxide mixture. The substrate W is thereby processed by the sulfuric acid/hydrogen peroxide mixture during the first period.

Here, the flow rate of the sulfuric acid flowing through the piping 52a is Fs1, and the temperature of the sulfuric acid is Ts1 in the first processing. The flow rate of the hydrogen peroxide water flowing through the piping 52b is Fh1, and the temperature of the hydrogen peroxide water is Th1 in the first processing. Also, the flow rate of the sulfuric acid/hydrogen peroxide mixture is Fc1, and the temperature of the sulfuric acid/hydrogen peroxide mixture is Tc1, and the sulfuric acid ratio of the sulfuric acid/hydrogen peroxide mixture is Rc1 in the first processing. Also, the rotation speed of the substrate W is Rr1 in the first processing.

Sulfuric acid and hydrogen peroxide water are mixed, and, as a result, a sulfuric acid/hydrogen peroxide mixture is generated. At this time, the sulfuric acid and the hydrogen peroxide water induce an exothermic reaction. Therefore, the temperature Tc1 of the sulfuric acid/hydrogen peroxide mixture is higher than both the temperatures Ts1 of the sulfuric acid and the temperature Th1 of the hydrogen peroxide water.

For example, the temperature Ts1 of the sulfuric acid is not less than 70°C and not more than 220°C, and may be not less than 100°C and not more than 200°C. Also, the temperature Th1 of the hydrogen peroxide water is room temperature. For example, the temperature Tc1 of the sulfuric acid/hydrogen peroxide mixture is not less than 90°C and not more than 240°C.

The substrate W is hydrophilized by the first processing. Here, the flow rate Fc1 of the sulfuric acid/hydrogen peroxide mixture is comparatively large, and therefore it is possible to swiftly cover the substrate W with the sulfuric acid/hydrogen peroxide mixture.

It is noted that, in the first processing, there is a case in which the sulfuric acid/hydrogen peroxide mixture supplied to the substrate W splashes from the substrate W, and adheres to the chamber 11. Therefore, preferably, the first processing is performed so that liquid droplets of the sulfuric acid/hydrogen peroxide mixture do not splash from the substrate W. For example, if the sulfuric acid ratio of the sulfuric acid/hydrogen peroxide mixture is comparatively low in the first processing, the sulfuric acid/hydrogen peroxide mixture splashes from the substrate W, and adheres to the chamber 11 in some cases. Therefore, preferably, the sulfuric acid ratio of the sulfuric acid/hydrogen peroxide mixture is set to be comparatively high.

Typically, the flow rate Fs1 of the sulfuric acid is larger than the flow rate Fh1 of the hydrogen peroxide water. For example, in the first processing, the sulfuric acid and the hydrogen peroxide water are mixed at the ratio of 4:1 to 9:1 (i.e., the flow rate of the sulfuric acid to the flow rate of the hydrogen peroxide water is set to be not less than four times and not more than nine times).

Also, if the rotation speed of the substrate W is comparatively high in the first processing, the sulfuric acid/hydrogen peroxide mixture splashes from the substrate W, and adheres to the chamber in some cases. Therefore, preferably, the rotation speed Rr1 of the substrate W in the first processing is lower than a threshold value. For example, the rotation speed Rr1 of the substrate W in the first processing is not less than 700 rpm and not more than 1400 rpm, and may be not less than 800 rpm and not more than 1200 rpm.

As shown in FIG. 7(c), the sulfuric acid/hydrogen peroxide mixture is supplied to the substrate W and the second processing is applied onto the substrate W. The SPM supplying portion 50 continuously supplies the sulfuric acid/hydrogen peroxide mixture to the substrate W from the nozzle 56 while controlling the controlling portion 102. The condition of the second processing differs from the condition of the first processing. Here, the sulfuric acid/hydrogen peroxide mixture is supplied to the substrate W, and the substrate W is processed by the sulfuric acid/hydrogen peroxide mixture.

In the second processing, the substrate W is processed by the sulfuric acid/hydrogen peroxide mixture whose flow rate is low and whose sulfuric acid ratio is low. At this time, the sulfuric acid/hydrogen peroxide mixture forms a film having a liquid thickness L2. The liquid thickness L2 in the second processing is smaller than the liquid thickness L1 in the first processing.

In the second processing, the opening degree of at least either one of the valve 54a and the valve 54b in the first processing is changed. For example, in the second processing, the opening degree of the valve 54a in the first processing is reduced, and the flow rate of the sulfuric acid is reduced. It is noted that, in the second processing, the opening degree of the valve 54b in the first processing may be changed, and the flow rate of the hydrogen peroxide water may be changed.

Here, the flow rate of the sulfuric acid flowing through the piping 52a is Fs2, and the temperature of the sulfuric acid is Ts2 in the second processing. In the second processing, the flow rate of the hydrogen peroxide water flowing through the piping 52b is Fh2, and the temperature of the hydrogen peroxide water is Th2. Also, in the second processing, the flow rate of the sulfuric acid/hydrogen peroxide mixture is Fc2, and the temperature of the sulfuric acid/hydrogen peroxide mixture is Tc2, and the sulfuric acid ratio of the sulfuric acid/hydrogen peroxide mixture is Rc2. Also, in the second processing, the rotation speed of the substrate W is Rr2.

In the second processing, the substrate W that has been hydrophilized is processed with the sulfuric acid/hydrogen peroxide mixture. Here, from the viewpoint of cost reductions and impacts on environment, preferably, the flow rate Fc2 of the sulfuric acid/hydrogen peroxide mixture to the substrate W is comparatively low. Also, preferably, the sulfuric acid/hydrogen peroxide mixture is prepared at a ratio at which the processing of the substrate W proceeds efficiently.

Typically, here, the flow rate Fs2 of the sulfuric acid is likewise higher than the flow rate Fh2 of the hydrogen peroxide water. For example, in the second processing, the sulfuric acid and the hydrogen peroxide water are mixed at the ratio of 2:1 to 3:1 (i.e., the flow rate of the sulfuric acid to the flow rate of the hydrogen peroxide water is set to be not less than two times and not more than three times).

For example, the temperature Ts2 of the sulfuric acid is not less than 70°C and not more than 220°C, and may be not less than 100°C and not more than 200°C. Also, the temperature Th2 of the hydrogen peroxide water is room temperature. For example, the temperature Tc2 of the sulfuric acid/hydrogen peroxide mixture is not less than 90°C and not more than 240°C.

Here, when the first processing and the second processing are compared with each other, the flow rate Fc2 of the sulfuric acid/hydrogen peroxide mixture in the second processing is smaller than the flow rate Fc1 of the sulfuric acid/hydrogen peroxide mixture in the first processing. This makes it possible to suppress the adhesion of particles to the substrate W by swiftly covering the substrate W with the sulfuric acid/hydrogen peroxide mixture, and also makes it possible to reduce the amount of consumption of the sulfuric acid/hydrogen peroxide mixture. For example, the flow rate Fc2 of the sulfuric acid/hydrogen peroxide mixture in the second processing is not less than 30% and not more than 85% of the flow rate Fc1 of the sulfuric acid/hydrogen peroxide mixture in the first processing, and may be not less than 40% and not more than 75% thereof.

For example, the temperature Ts2 of the sulfuric acid in the second processing may be equal to the temperature Ts1 of the sulfuric acid in the first processing. In this case, the heating temperature of the heater 55a is not necessarily required to be changed in the first processing and in the second processing. Likewise, the temperature Th2 of the hydrogen peroxide water in the second processing may be equal to the temperature Th1 of the hydrogen peroxide water in the first processing.

It is noted that, the temperature Tc2 of the sulfuric acid/hydrogen peroxide mixture in the second processing differs from the temperature Tc1 of the sulfuric acid/hydrogen peroxide mixture in the first processing even when the temperature Ts2 of the sulfuric acid and the temperature Th2 of the hydrogen peroxide water in the second processing are equal to the temperature Ts1 of the sulfuric acid and the temperature Th1 of the hydrogen peroxide water in the first processing. Typically, the temperature Tc2 of the sulfuric acid/hydrogen peroxide mixture in the second processing becomes higher than the temperature Tc1 of the sulfuric acid/hydrogen peroxide mixture in the first processing. The reason is that the sulfuric acid ratio Rs2 of the sulfuric acid/hydrogen peroxide mixture is smaller than the sulfuric acid ratio Rs1 of the sulfuric acid/hydrogen peroxide mixture.

Also, the sulfuric acid ratio Rc2 of the sulfuric acid/hydrogen peroxide mixture in the second processing is smaller than the sulfuric acid ratio Rc1 of the sulfuric acid/hydrogen peroxide mixture in the first processing. Hence, the substrate W is enabled to be efficiently subjected to SPM processing by use of a comparatively small amount of sulfuric acid/hydrogen peroxide mixture.

The rotation speed Rr2 of the substrate W in the second processing may be smaller than the rotation speed Rr1 of the substrate W in the first processing. Hence, the substrate W is enabled to be efficiently subjected to SPM processing by use of a comparatively small amount of sulfuric acid/hydrogen peroxide mixture.

However, if the rotation speed Rr2 of the substrate W in the second processing is too small, the sulfuric acid/hydrogen peroxide mixture on the substrate W drips downwardly from the substrate W, and the sulfuric acid/hydrogen peroxide mixture adheres to the substrate holding portion 20 in some cases. Therefore, preferably, the rotation speed Rr2 of the substrate W in the second processing is higher than a predetermined value. For example, the rotation speed Rr2 of the substrate W in the second processing may be not less than 100 rpm and not more than 500 rpm, and may be not less than 150 rpm and not more than 300 rpm.

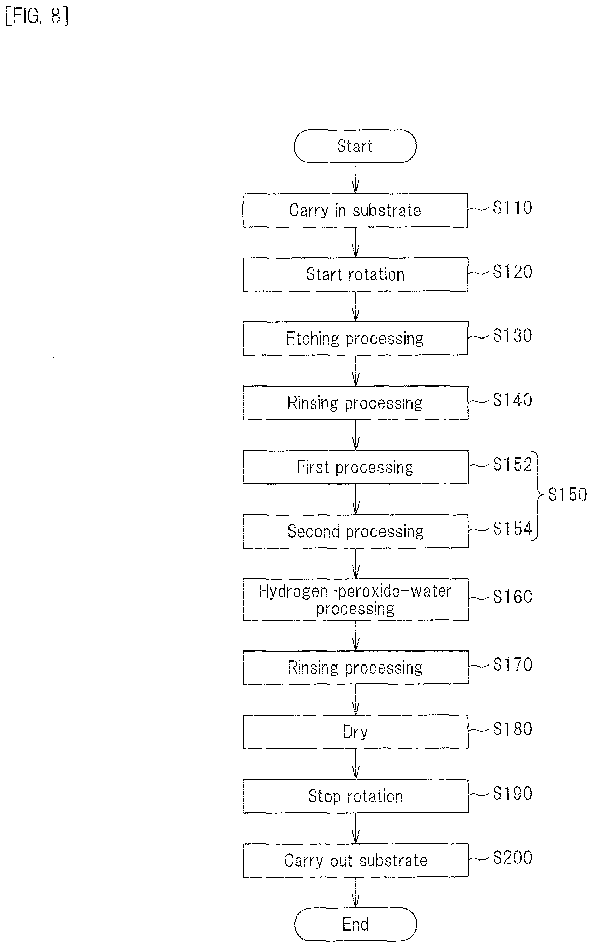

Next, referring to FIG. 1 to FIG. 8, the substrate processing method of the present preferred embodiment will be described. FIG. 8 is a flowchart of the substrate processing method of the present preferred embodiment.

As shown in FIG. 8, in step S110, a substrate W is carried into the chamber 11. The center robot CR carries the substrate W into the chamber 11, and the substrate holding portion 20 holds the substrate W carried thereinto while controlling the controlling portion 102.

In step S120, the rotation of the substrate W is started. The substrate holding portion 20 starts the rotation of the substrate W in a state of holding the substrate W while controlling the controlling portion 102.

In step S130, an etching liquid is supplied to the substrate W, and the substrate W is etched. The etching liquid supplying portion 30 supplies the etching liquid from the nozzle 36 to the substrate W that is being rotated by the substrate holding portion 20 while controlling the controlling portion 102. For example, the etching liquid supplying portion 30 supplies hydrofluoric acid as the etching liquid. In this case, a natural oxide film on the substrate W is removed, and the substrate W is hydrophobized by use of the hydrofluoric acid.

In step S140, a rinse liquid is supplied to the substrate W, and the substrate W is rinsed. The rinse liquid supplying portion 40 supplies a rinse liquid from the nozzle 46 to the substrate W while controlling the controlling portion 102. For example, the rinse liquid supplying portion 40 supplies carbonated water as the rinse liquid.

In step S150, a sulfuric acid/hydrogen peroxide mixture is supplied to the substrate W, and the substrate W is subjected to SPM processing. The SPM supplying portion 50 supplies a sulfuric acid/hydrogen peroxide mixture from the nozzle 56 to the substrate W while controlling the controlling portion 102. Organic substances are removed from the substrate W, and a chemical oxide film is generated by the SPM processing.

Step S150 includes step S152 in which the first processing is performed in the first period and step S154 in which the second processing is performed in the second period subsequent to the first period. The second period of the second processing is longer than the first period of the first processing. Typically, the first period is equal to or less than ten seconds, and may be not less than one second and not more than five seconds. On the other hand, the second period is equal to or more than 30 seconds, and may be not less than one minute and not more than five minutes.

In step S152, the substrate W is processed by use of a sulfuric acid/hydrogen peroxide mixture during the first period. In the first processing, the substrate W is processed by use of the sulfuric acid/hydrogen peroxide mixture of both the flow rate Fc1 and the sulfuric acid ratio Rc1. At this time, the substrate W is rotated at the rotation speed Rr1.

In step S154, the substrate W is processed by use of the sulfuric acid/hydrogen peroxide mixture during the second period. In the second processing, the substrate W is processed by use of the sulfuric acid/hydrogen peroxide mixture of both the flow rate Fc2 and the sulfuric acid ratio Rc2. Here, the flow rate Fc2 is smaller than the flow rate Fc1. Also, the sulfuric acid ratio Rc2 is smaller than the sulfuric acid ratio Rc1. At this time, the substrate W is rotated at the rotation speed Rr2. The rotation speed Rr2 may be lower than the rotation speed Rr1.

In step S160, hydrogen peroxide water is supplied to the substrate W, and the substrate W is processed by use of the hydrogen peroxide water. Here, the supply of the sulfuric acid to the substrate W is stopped, and the hydrogen peroxide water is continuously supplied to the substrate W. In detail, the valve 54a is closed, and the flow of the sulfuric acid in the piping 52a is stopped, and meanwhile, the hydrogen peroxide water continuously flows through the piping 52b in a state of keeping the valve 54b open. However, the flow rate of the hydrogen peroxide water in the piping 52b may be changed by changing the opening degree of the valve 54b as necessary.

In step S170, a rinse liquid is supplied to the substrate W, and the substrate W is rinsed. The rinse liquid supplying portion 60 supplies a rinse liquid from the nozzle 66 to the substrate W while controlling the controlling portion 102. For example, the rinse liquid supplying portion 60 supplies pure water as the rinse liquid.

In step S180, the substrate W is dried. The substrate holding portion 20 increases the rotation speed of the substrate W, and blows away the rinse liquid on the substrate W by means of a centrifugal force while controlling the controlling portion 102.

In step S190, the rotation of the substrate W is stopped. The substrate holding portion 20 stops the rotation of the substrate W while controlling the controlling portion 102.

In step S200, the substrate W is taken out of the substrate processing unit 10. The substrate holding portion 20 releases the holding of the substrate W, and the center robot CR takes out the substrate W from the chamber 11 while controlling the controlling portion 102. Thereafter, the substrate W is transferred to the outside of the substrate processing apparatus 100 through the indexer robot IR.

According to the substrate processing method of the present preferred embodiment, it is possible to process the substrate W in a way as above. According to the present preferred embodiment, it is possible to remove organic substances on the substrate W while suppressing the splash of the sulfuric acid/hydrogen peroxide mixture from the substrate W.

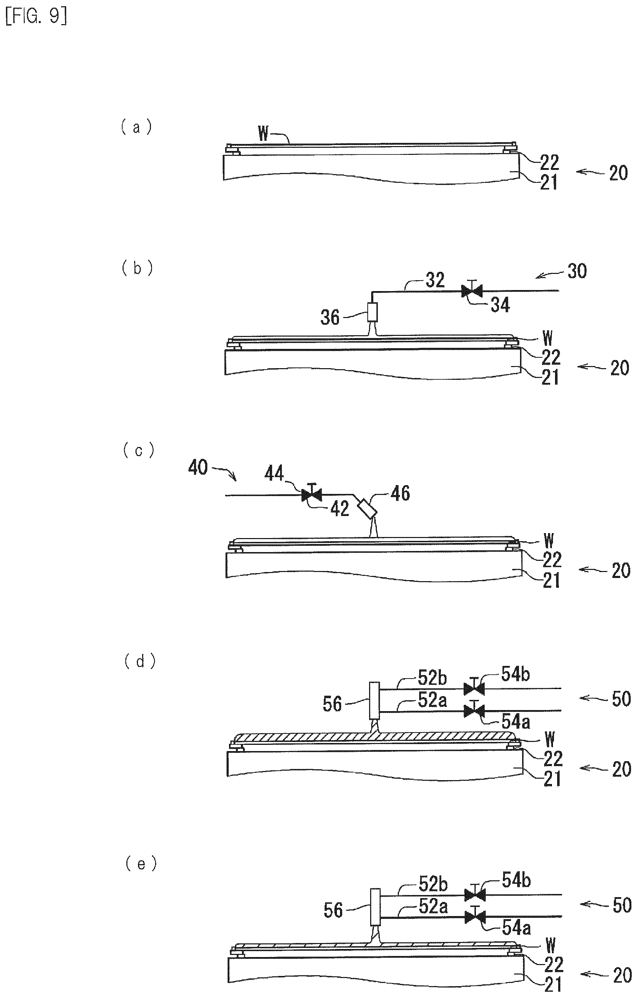

Thereafter, referring to FIG. 1 to FIG. 10, the substrate processing method in the substrate processing apparatus 100 of the present preferred embodiment will be described. FIG. 9(a) to FIG. 10(c) are schematic views of the substrate processing method of the present preferred embodiment.

As shown in FIG. 9(a), the substrate holding portion 20 holds the substrate W. The substrate holding portion 20 holds the transferred substrate W while controlling the controlling portion 102.

As shown in FIG. 9(b), the substrate W is rotated and an etching liquid is supplied to the substrate W, and the substrate W is etched. The substrate holding portion 20 rotates the substrate W held thereby while controlling the controlling portion 102, and the etching liquid supplying portion 30 supplies an etching liquid from the nozzle 36 to the substrate W and the substrate W is etched. For example, hydrofluoric acid is supplied from the nozzle 36 to the substrate W, and the substrate W is subjected to hydrofluoric acid processing. It is possible to remove a natural oxide film on the substrate W by the hydrofluoric acid processing. The substrate W is hydrophobized by the hydrofluoric acid processing.

As shown in FIG. 9(c), a rinse liquid is supplied to the substrate W and the substrate W is rinsed. The rinse liquid supplying portion 40 supplies a rinse liquid from the nozzle 46 to the substrate W while controlling the controlling portion 102, and the substrate W is rinsed. For example, carbonated water is supplied from the nozzle 46 to the substrate W, and the substrate W is rinsed.

As shown in FIG. 9(d), the substrate W is processed by use of a sulfuric acid/hydrogen peroxide mixture. In the first processing, the substrate W is processed by use of a sulfuric acid/hydrogen peroxide mixture of both the flow rate Fc1 and the sulfuric acid ratio Rc1. The SPM supplying portion 50 supplies the sulfuric acid/hydrogen peroxide mixture from the nozzle 56 to the substrate W while controlling the controlling portion 102, and the substrate W is subjected to SPM processing. In detail, the valve 54a is opened, and sulfuric acid flows though the piping 52a, and the valve 54b is opened, and hydrogen peroxide water flows through the piping 52b.

As shown in FIG. 9(e), the substrate W is processed by use of a sulfuric acid/hydrogen peroxide mixture. In the second processing, the substrate W is processed by use of the sulfuric acid/hydrogen peroxide mixture of both the flow rate Fc2 and the sulfuric acid ratio Rc2. The SPM supplying portion 50 continuously supplies the sulfuric acid/hydrogen peroxide mixture from the nozzle 56 to the substrate W while controlling the controlling portion 102, and SPM processing is continuously applied onto the substrate W.

In the second processing, the flow rate Fc2 is made smaller than the flow rate Fc1, and the sulfuric acid ratio Rc2 is made smaller than the sulfuric acid ratio Rc1. In detail, the opening degree of the valve 54a is reduced, and the flow rate of the sulfuric acid flowing through the piping 52a is reduced. At this time, the flow rate of the hydrogen peroxide water flowing through the piping 52b may be changed by changing the opening degree of the valve 54b.

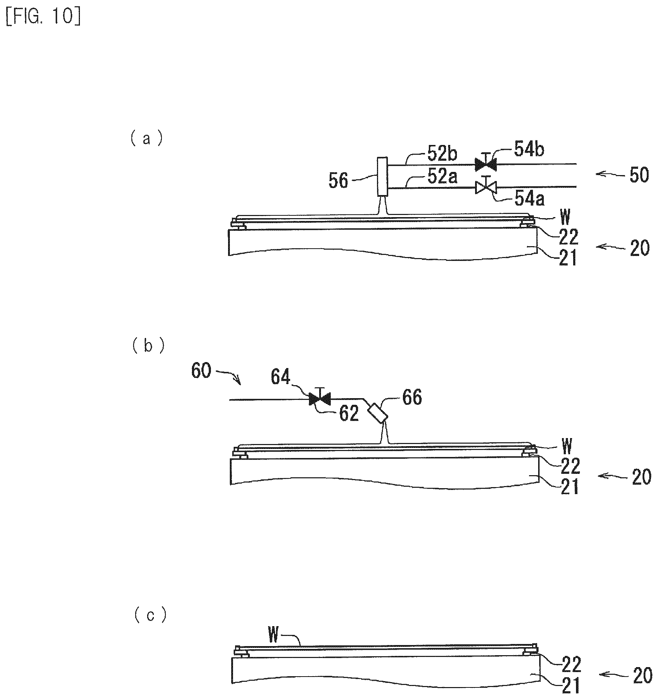

As shown in FIG. 10(a), hydrogen peroxide water is supplied to the substrate W and the substrate W is processed by use of the hydrogen peroxide water. The SPM supplying portion 50 supplies the hydrogen peroxide water from the nozzle 56 to the substrate W while controlling the controlling portion 102, and processes the substrate W by use of the hydrogen peroxide water. Here, the supply of the sulfuric acid to the substrate W is stopped, and the supply of the hydrogen peroxide water to the substrate W is continuously performed. In detail, the valve 54a is closed, and the flow of the sulfuric acid flowing through the piping 52a is stopped in a state in which the hydrogen peroxide water continues flowing through the piping 52b in a state of keeping the valve 54b open. At this time, the flow rate of the hydrogen peroxide water flowing through the piping 52b may be changed by changing the opening degree of the valve 54b.

As shown in FIG. 10(b), a rinse liquid is supplied to the substrate W and the substrate W is rinsed. The rinse liquid supplying portion 60 supplies a rinse liquid from the nozzle 66 to the substrate W while controlling the controlling portion 102, and the substrate W is rinsed.

As shown in FIG. 10(c), the substrate W is dried. The substrate holding portion 20 increases the rotation speed at which the substrate W is rotated while controlling the controlling portion 102. Thereafter, the rotation of the substrate W is stopped, and the substrate W is taken out of the substrate processing unit 10.

It is possible to process the substrate W in a way as above. In the present preferred embodiment, the substrate W is first processed by use of the sulfuric acid/hydrogen peroxide mixture having a high flow rate and having a high sulfuric acid ratio, and the substrate W is then processed by use of the sulfuric acid/hydrogen peroxide mixture having a low flow rate and having a low sulfuric acid ratio. Therefore, it is possible to efficiently apply SPM processing onto the substrate W while suppressing the splash of liquid droplets of the sulfuric acid/hydrogen peroxide mixture from the substrate W.

It is noted that, in the above description with reference to FIG. 1 to FIG. 10, the SPM processing is performed in a state in which the process is divided into two steps while the hydrogen-peroxide-water processing is performed through a single step; however, the present preferred embodiment is not limited thereto. The hydrogen-peroxide-water processing may be performed in a state in which the process is divided into two steps.

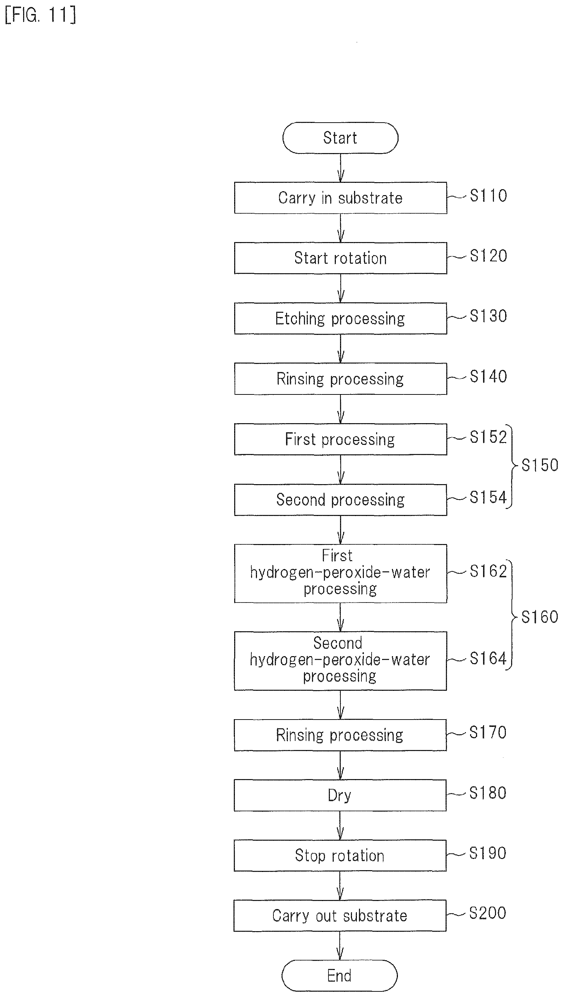

Next, referring to FIG. 11, the substrate processing method of the present preferred embodiment will be described. FIG. 11 is a flowchart of the substrate processing method of the present preferred embodiment. The flowchart of FIG. 11 is the same as the above flowchart described with reference to FIG. 8 except that the hydrogen-peroxide-water processing includes two processing steps, and a repetitive description is omitted to avoid redundancy.

As shown in FIG. 11, Step S110 to step S154 are the same as those of FIG. 8.

In step S160, the substrate W, which has been subjected to SPM processing, is processed by use of hydrogen peroxide water. Here, hydrogen peroxide water is supplied to the substrate W, and the substrate W is processed by use of the hydrogen peroxide water. The valve 54a is closed, and, on the other hand, the valve 54b remains opened. The opening degree of the valve 54b may be changed as necessary.

Step S160 includes step S162 in which first hydrogen-peroxide-water processing is performed and step S164 in which second hydrogen-peroxide-water processing is performed. The processing period of the second hydrogen-peroxide-water processing is longer than the processing period of the first hydrogen-peroxide-water processing.

In step S162, hydrogen peroxide water is supplied to the substrate W, and the first hydrogen-peroxide-water processing is performed. In the first hydrogen-peroxide-water processing, the flow rate of the hydrogen peroxide water flowing through the piping 52b is Fhh1, and the substrate W is processed by use of the sulfuric acid/hydrogen peroxide mixture of the flow rate Fhh1. Also, in the first hydrogen-peroxide-water processing, the substrate W is subjected to the hydrogen-peroxide-water processing by use of the sulfuric acid/hydrogen peroxide mixture of the flow rate Fhh1.

In step S164, hydrogen peroxide water is supplied to the substrate W and the second hydrogen-peroxide-water processing is performed. In the second hydrogen-peroxide-water processing, the flow rate of the hydrogen peroxide water flowing through the piping 52b is Fhh2, and the flow rate Fhh2 in the second hydrogen-peroxide-water processing is large than the flow rate Fhh1 in the first hydrogen-peroxide-water processing.

Thereafter, step S170 to step S200 are performed in the same way as in FIG. 8.

It is possible to process the substrate W in a way as above. In the present preferred embodiment, the substrate W is first processed by use of the sulfuric acid/hydrogen peroxide mixture having a high flow rate and having a high sulfuric acid ratio, and thereafter, the substrate W is processed by use of the sulfuric acid/hydrogen peroxide mixture having a low flow rate and having a low sulfuric acid ratio. Therefore, the substrate W is enabled to be efficiently subjected to the SPM processing while suppressing the splash of liquid droplets of the sulfuric acid/hydrogen peroxide mixture from the substrate W.

Further, the flow rate Fhh1 of the first hydrogen-peroxide-water processing after the substrate W has been subjected to the SPM processing is comparatively small, and, as a result, it is possible to suppress the occurrence of liquid splashes as a result of an overreaction between sulfuric-acid residual components and hydrogen peroxide water on the substrate W. Also, the hydrogen peroxide water having a comparatively high flow rate Fhh2 is thereafter supplied in the second hydrogen-peroxide-water processing, it is thereby made possible to effectively remove sulfuric-acid residual components on the substrate W.

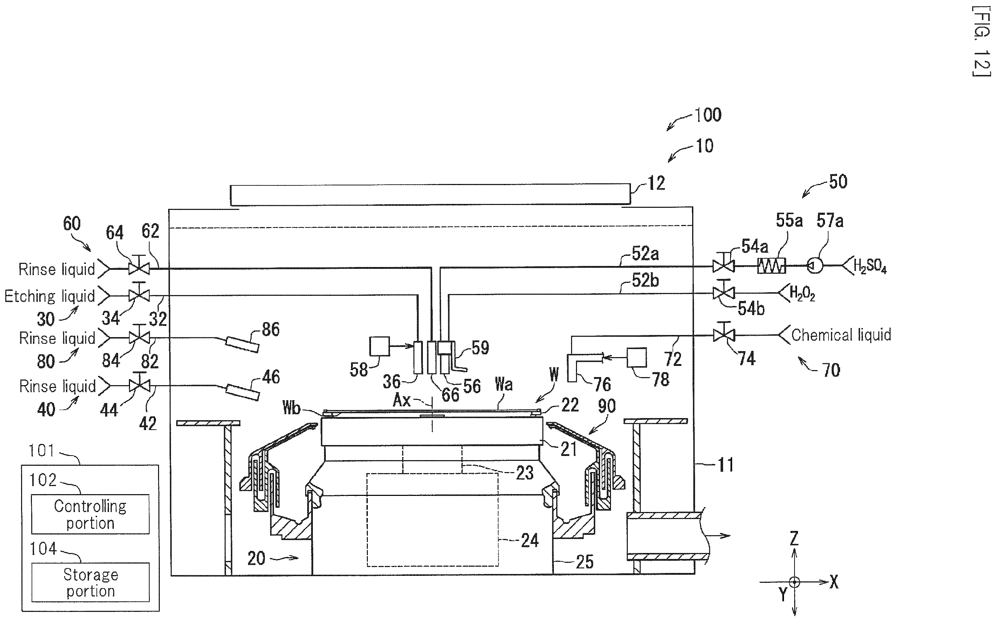

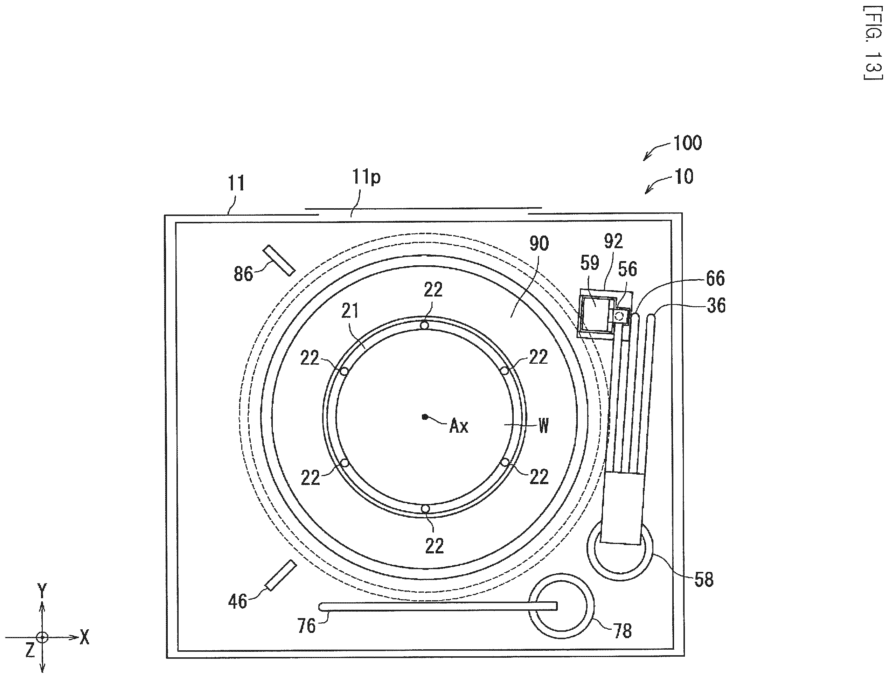

Next, referring to FIG. 1 to FIG. 13, the substrate processing apparatus 100 of the present preferred embodiment will be described. FIG. 12 is a schematic view of the substrate processing unit 10 of the substrate processing apparatus 100 of the present preferred embodiment, and FIG. 13 is a schematic top view of the substrate processing unit 10 of FIG. 12. The substrate processing unit 10 of FIG. 12 further includes a chemical liquid supplying portion 70 and a rinse liquid supplying portion 80, and the nozzle 36 of the etching liquid supplying portion 30, the nozzle 56 of the SPM supplying portion 50, and the nozzle 66 of the rinse liquid supplying portion 60 are integrally provided, and a splash suppression member 59 is attached to the nozzle 56 that discharges an SPM in an oblique direction, and, except for these points, the substrate processing unit 10 of FIG. 12 is arranged in the same way as the substrate processing unit 10 of the substrate processing apparatus 100 of FIG. 2, and a repetitive description is omitted to avoid redundancy.

As shown in FIG. 12, the substrate processing unit 10 further includes the chemical liquid supplying portion 70 and the rinse liquid supplying portion 80. The chemical liquid supplying portion 70 supplies a chemical liquid to the substrate W. Typically, the chemical liquid supplying portion 70 supplies a chemical liquid to the upper surface Wa of the substrate W. At least a portion of the chemical liquid supplying portion 70 is housed in the chamber 11.

The chemical liquid supplying portion 70 supplies a chemical liquid to the upper surface Wa of the substrate W. The chemical liquid includes an SC1 (mixture of ammonia water, hydrogen peroxide water, and water).

The chemical liquid supplying portion 70 includes a piping 72, a valve 74, and a nozzle 76. The nozzle 76 discharges a chemical liquid to the upper surface Wa of the substrate W. The nozzle 76 is connected to the piping 72. A chemical liquid is supplied from a supply source to the piping 72. The valve 74 opens and closes a flow path in the piping 72.

The valve 74 opens and closes the flow path in the piping 72. The valve 74 adjusts the opening degree of the piping 72, and adjusts the flow rate of a chemical liquid supplied to the piping 72. In detail, the valve 74 includes a valve body (not shown) inside which a valve seat is provided, a valve element to open and close the valve seat, and an actuator (not shown) to move the valve element between an open position and a closed position.

The nozzle 76 may be arranged such as to be movable with respect to the substrate W. The chemical liquid supplying portion 70 may further have a nozzle moving portion 78. The nozzle moving portion 78 may elevate and lower the nozzle 76, or may horizontally turn the nozzle 76 around a turning axis. The nozzle moving portion 78 elevates and lowers the nozzle 76. For example, the nozzle moving portion 78 includes a ball screw mechanism and an electric motor that gives a driving force to the ball screw mechanism. Also, the nozzle moving portion 78 horizontally turns the nozzle 76. For example, the nozzle moving portion 78 includes an electric motor.

The rinse liquid supplying portion 80 supplies a rinse liquid to the substrate W. Typically, the rinse liquid supplying portion 80 supplies a rinse liquid to the upper surface Wa of the substrate W. At least a portion of the rinse liquid supplying portion 80 is housed in the chamber 11.

The rinse liquid supplying portion 80 supplies a rinse liquid to the upper surface Wa of the substrate W. The rinse liquid includes deionized water (DIW), electrolyzed ion water, or ozone water. Alternatively, the rinse liquid may be a liquid except these kinds of water. As an example, ammonia water, aqueous hydrochloric acid solution of dilute concentration (for example, approximately 10 ppm to 100 ppm), and reduced water (hydrogen water) can be mentioned as the rinse liquid.

The rinse liquid supplying portion 80 includes a piping 82, a valve 84, and a nozzle 86. The nozzle 86 discharges a rinse liquid to the upper surface Wa of the substrate W. The nozzle 86 is connected to the piping 82. The rinse liquid is supplied from the supply source to the piping 82. The valve 84 opens and closes a flow path in the piping 82. The nozzle 86 may be arranged such as to be movable with respect to the substrate W.

The valve 84 opens and closes the flow path in the piping 82. The valve 84 adjusts the opening degree of the piping 82, and adjusts the flow rate of the rinse liquid supplied to the piping 82. In detail, the valve 84 includes a valve body (not shown) inside which a valve seat is provided, a valve element to open and close the valve seat, and an actuator (not shown) to move the valve element between an open position and a closed position. The nozzle 86 may be arranged such as to be movable with respect to the substrate W.

The nozzle 36 of the etching liquid supplying portion 30, the nozzle 56 of the SPM supplying portion 50, and the nozzle 66 of the rinse liquid supplying portion 60 are integrally provided. Therefore, when the kinds of liquids supplied to the substrate W are switched, it is possible to shorten the moving time of the nozzles 36, 56, 66, and is possible to improve the throughput of substrate processing.

Here, the nozzle 56 discharges a sulfuric acid/hydrogen peroxide mixture in an oblique rightward downward direction. The nozzle 56 discharges a sulfuric acid/hydrogen peroxide mixture in an oblique direction, and, as a result, even when liquid droplets of the sulfuric acid/hydrogen peroxide mixture splashes from the substrate W, it is possible to suppress the adhesion of liquid droplets of the sulfuric acid/hydrogen peroxide mixture to the nozzle 56.

Also, the splash suppression member 59 is attached to the nozzle 56. The splash suppression member 59 is attached to the nozzle 56 in a direction in which the sulfuric acid/hydrogen peroxide mixture is discharged from the nozzle 56. The splash suppression member 59 faces a position of the substrate W at which the sulfuric acid/hydrogen peroxide mixture discharged from the nozzle 56 reaches the substrate W. Hence, even when the sulfuric acid/hydrogen peroxide mixture discharged to the substrate W splashes from the substrate W, it is possible, by the splash suppression member 59, to suppress liquid droplets splashed from the substrate W from adhering to the surroundings.

It is noted that, as shown in FIG. 13, the splash suppression member 59 is housed in a standby pod 92 together with the nozzle 56. When the nozzle 56 is placed at a standby position, the standby pod 92 is placed at a position with which the nozzle 56 and the splash suppression member 59 overlap. The standby pod 92 houses the nozzle 56 and the splash suppression member 59. It is noted that, in the standby pod 92, preferably, the nozzle 56 and the splash suppression member 59 are washable.

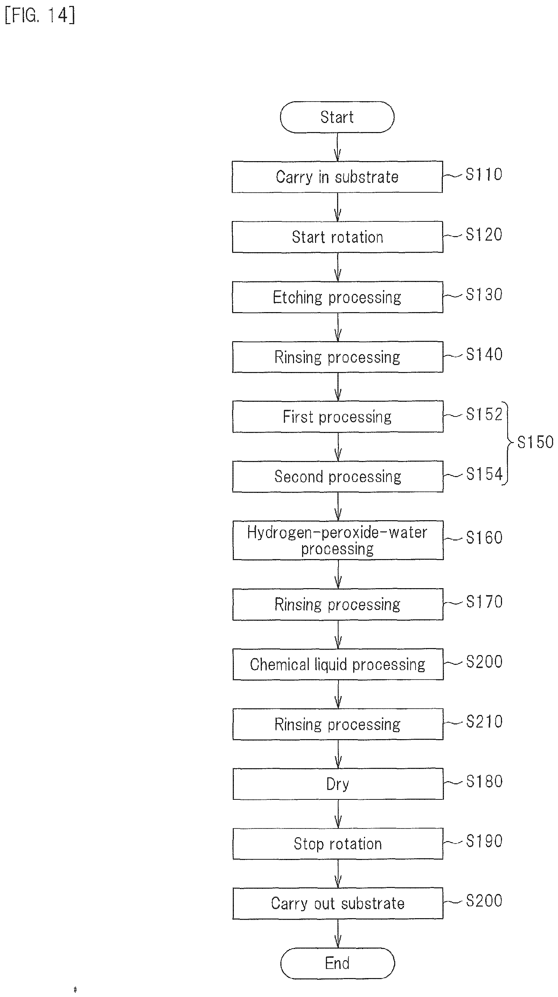

Next, referring to FIG. 12 to FIG. 14, the substrate processing method of the present preferred embodiment will be described. FIG. 14 is a flowchart of the substrate processing method of the present preferred embodiment. Except that chemical liquid processing and rinsing processing are further included, the flowchart of FIG. 14 is the same as the flowchart mentioned with reference to FIG. 8, and a repetitive description is omitted to avoid redundancy.

As shown in FIG. 14, the process from step S110 to step S170 is the same as in FIG. 8.

Subsequent to step S170, in step S200, chemical liquid is supplied to the substrate W. The substrate W is thereby subjected to chemical liquid processing. The chemical liquid supplying portion 70 supplies a chemical liquid from the nozzle 76 to the substrate W while controlling the controlling portion 102.

In step S210, a rinse liquid is supplied to the substrate W. The substrate W is thereby subjected to rinsing processing. The rinse liquid supplying portion 80 supplies a rinse liquid from the nozzle 86 to the substrate W while controlling the controlling portion 102.

Thereafter, subsequent to step S210, in step S180, the substrate W is dried. The substrate W is thereby dried. The process from step S180 to step S200 is the same as in FIG. 8, and therefore a description of this process is omitted.

The preferred embodiments of the present invention have been described above with reference to the accompanying drawings. However, the present invention is not limited to the above preferred embodiments and can be implemented in various modes without departing from the gist thereof. Also, the plurality of constituent elements disclosed in the above preferred embodiments can be modified appropriately. For example, one constituent element among all constituent elements illustrated in one preferred embodiment may be added to the constituent elements of another preferred embodiment, or some constituent elements among all constituent elements illustrated in one preferred embodiment may be deleted from the preferred embodiment.

Also, the drawings schematically show the respective constituent elements mainly in order to facilitate understanding of the present invention, and the thickness, the length, the number, the interval, etc., of each constituent element shown in the figures may be different from the actual ones for convenience in creating the drawings. Also, the configuration of each constituent element illustrated in the above preferred embodiments are merely examples, and are not particularly limited, and various modifications can be made without substantially departing from the effects of the present invention.

For example, in the substrate processing unit 10 shown in FIG. 2, FIG. 7, FIG. 9, FIG. 10, and FIG. 12, the sulfuric acid/hydrogen peroxide mixture is generated by mixing sulfuric acid and hydrogen peroxide water in the nozzle 56 inside the chamber 11; however, the present preferred embodiments are not limited thereto. The sulfuric acid/hydrogen peroxide mixture may be generated by mixing sulfuric acid and hydrogen peroxide water outside the chamber 11.

### Industrial Applicability

The present invention is applicable to the field of the substrate processing apparatus and the substrate processing method.

### Reference Signs List

- 20: substrate holding portion

- 30: etching liquid supplying portion
- 40: rinse liquid supplying portion
- 50: SPM supplying portion
- 60: rinse liquid supplying portion
- 100: substrate processing apparatus
- 101: controller
- 102: controlling portion
- 104: storage portion

## Claims

1. A substrate processing apparatus comprising:
a substrate holding portion to hold and rotate a substrate; and
a mixture supplying portion to supply a sulfuric acid/hydrogen peroxide mixture, in which sulfuric acid and hydrogen peroxide water are to be mixed, to the substrate that is rotated by the substrate holding portion,
wherein the mixture supplying portion supplies the sulfuric acid/hydrogen peroxide mixture to the substrate at a first flow rate during a first period, and supplies the sulfuric acid/hydrogen peroxide mixture to the substrate at a second flow rate that is smaller than the first flow rate during a second period subsequent to the first period, and
wherein a ratio of the sulfuric acid of the sulfuric acid/hydrogen peroxide mixture during the second period is smaller than a ratio of the sulfuric acid of the sulfuric acid/hydrogen peroxide mixture during the first period.

2. The substrate processing apparatus according to claim 1, further comprising an etching liquid supplying portion to supply an etching liquid to the substrate before the mixture supplying portion supplies the sulfuric acid/hydrogen peroxide mixture to the substrate.

3. The substrate processing apparatus according to claim 2, wherein the etching liquid supplying portion supplies hydrofluoric acid or diluted hydrofluoric acid to the substrate as the etching liquid.

4. The substrate processing apparatus according to any one of claim 1 to claim 3, wherein the mixture supplying portion supplies the sulfuric acid/hydrogen peroxide mixture, which is generated by mixing the sulfuric acid of not less than 130°C and not more than 200°C and the hydrogen peroxide water of room temperature, to the substrate.

5. The substrate processing apparatus according to any one of claim 1 to claim 4, wherein
the mixture supplying portion supplies the sulfuric acid/hydrogen peroxide mixture in which the sulfuric acid and the hydrogen peroxide water are mixed at a ratio of 4:1 to 9:1 during the first period to the substrate, and
supplies the sulfuric acid/hydrogen peroxide mixture in which the sulfuric acid and the hydrogen peroxide water are mixed at a ratio of 2:1 to 3:1 during the second period to the substrate.

6. The substrate processing apparatus according to any one of claim 1 to claim 5, wherein the second period is longer than the first period.

7. The substrate processing apparatus according to any one of claim 1 to claim 6, wherein the substrate holding portion rotates the substrate at a second rotation speed during the second period after rotating the substrate at a first rotation speed during the first period, and
the second rotation speed is smaller than the first rotation speed.

8. The substrate processing apparatus according to any one of claim 1 to claim 7, wherein the mixture supplying portion supplies the hydrogen peroxide water to the substrate after the second period.

9. The substrate processing apparatus according to any one of claim 1 to claim 8, further comprising a splash suppression member to suppress a splash of liquid droplets of the sulfuric acid/hydrogen peroxide mixture from the substrate.

10. A substrate processing method that comprises an SPM processing step of supplying a sulfuric acid/hydrogen peroxide mixture, which is generated by mixing sulfuric acid and hydrogen peroxide water, to a substrate held and rotated by a substrate holding portion and processing the substrate with the sulfuric acid/hydrogen peroxide mixture,
the SPM processing step including:
a first processing step of supplying the sulfuric acid/hydrogen peroxide mixture to the substrate at a first flow rate during a first period and processing the substrate; and
a second processing step of supplying the sulfuric acid/hydrogen peroxide mixture to the substrate at a second flow rate smaller than the first flow rate during a second period subsequent to the first period and processing the substrate, and
a ratio of the sulfuric acid of the sulfuric acid/hydrogen peroxide mixture during the second period is smaller than a ratio of the sulfuric acid of the sulfuric acid/hydrogen peroxide mixture during the first period.

11. The substrate processing method according to claim 10, further comprising an etching step of processing the substrate with an etching liquid before the SPM processing step.

12. The substrate processing method according to claim 11, wherein, in the etching step, hydrofluoric acid or diluted hydrofluoric acid is supplied to the substrate as the etching liquid.

13. The substrate processing method according to any one of claim 10 to claim 12, wherein, in the SPM processing step, the sulfuric acid/hydrogen peroxide mixture which is generated by mixing the sulfuric acid of not less than 130°C and not more than 220°C and the hydrogen peroxide water of room temperature is supplied to the substrate.

14. The substrate processing method according to any one of claim 10 to claim 13, wherein, in the first processing step, the sulfuric acid/hydrogen peroxide mixture in which the sulfuric acid and the hydrogen peroxide water are mixed at a ratio of 4:1 to 9:1 during the first period is supplied to the substrate, and
in the second processing step, the sulfuric acid/hydrogen peroxide mixture in which the sulfuric acid and the hydrogen peroxide water are mixed at a ratio of 2:1 to 3:1 during the second period is supplied to the substrate.

15. The substrate processing method according to any one of claim 10 to claim 14, wherein the second period is longer than the first period.

16. The substrate processing method according to any one of claim 10 to claim 15, wherein, in the SPM processing step, the substrate is rotated at a second rotation speed during the second period after rotating the substrate at a first rotation speed during the first period, and
the second rotation speed is smaller than the first rotation speed.

17. The substrate processing method according to any one of claim 10 to claim 16, further comprising a step of supplying the hydrogen peroxide water to the substrate after the second period and processing the substrate by use of the hydrogen peroxide water.

18. The substrate processing method according to any one of claim 10 to claim 17, wherein, in the SPM processing step, a splash of liquid droplets of the sulfuric acid/hydrogen peroxide mixture is suppressed by a splash suppression member that faces a position of the substrate at which the sulfuric acid/hydrogen peroxide mixture reaches the substrate.
